# EUROPEAN PATENT APPLICATION

(11) **EP 4 794 007 A1**
(43) Date of publication of application: **19.08.2026**
(21) Application number: 24928100.7
(22) Date of filing: 16.10.2024
(51) Int. Cl.: H01M 4/131, H01M 4/1391, H01M 4/04, H01M 4/70, H01M 50/533, C23C 16/56

(54) **ELECTRODE SHEET, ELECTRODE ASSEMBLY, BATTERY CELL AND PREPARATION METHOD THEREFOR, BATTERY, AND ELECTRIC DEVICE**

(30) Priority: 08.03.2024 CN 202410269745
(71) Applicant: Contemporary Amperex Technology Co., Limited, Ningde, Fujian 352100 (CN)
(72) Inventor: JI, Xing, Ningde, Fujian 352100 (CN); JIAO, Chennan, Ningde, Fujian 352100 (CN); PENG, Longqing, Ningde, Fujian 352100 (CN); LI, Jingli, Ningde, Fujian 352100 (CN); LI, Xing, Ningde, Fujian 352100 (CN)
(74) Representative: Ran, Handong
(86) International application number: PCT/CN2024/125375
(87) International publication number: WO 2025/185170

(57) **Abstract**

An electrode sheet, an electrode assembly, a battery cell and a preparation method therefor, a battery, and an electric device, relating to the technical field of batteries. A protective layer is provided on at least the surface of an end portion of the electrode sheet, and the protective layer comprises silicon oxide; and on the basis of the total mass of all elements of a first position of the electrode sheet, the mass content A of an Si element satisfies: A is less than 0.01 wt%, and the first position is a position 5 mm distant from the surface of the end portion.

## Description

### CROSS-REFERENCE TO RELATED APPLICATIONS

This patent claims priority to and benefits of Chinese Patent Application No. 202410269745.1, entitled "ELECTRODE PLATE, ELECTRODE ASSEMBLY, BATTERY CELL AND PREPARATION METHOD THEREFOR, BATTERY, AND POWER CONSUMING APPARATUS" filed on March 8, 2024, the entire content of which is incorporated in a part of content disclosed in this patent by reference in its entirety.

### TECHNICAL FIELD

The present application relates to the field of battery technologies, and in particular, to an electrode plate, an electrode assembly, a battery cell and a preparation method therefor, a battery, and a power consuming apparatus.

### BACKGROUND

As environmental pollution increasingly deteriorates, people increasingly concern about a new energy industry. In the new energy industry, battery technologies are an important factor related to development of the new energy industry.

Design factors in many aspects need to be considered for development of the battery technologies, such as an energy density, a cycle life, and reliability. A design of an electrode plate in a battery cell is crucial to reliability and cycling performance of the battery cell. Therefore, how to provide an electrode plate to improve the reliability and the cycling performance of the battery cell is a technical problem that needs to be resolved urgently.

### SUMMARY

The present application is proposed in view of the foregoing problem, and an objective of the present application is to provide an electrode plate to improve reliability and cycling performance of a battery cell.

To achieve the foregoing objective, the present application provides an electrode plate, an electrode assembly, a battery cell, a preparation method therefor, a battery, and a power consuming apparatus.

According to a first aspect, an electrode plate is provided, where a protective layer is arranged at least on an end surface of the electrode plate, and the protective layer includes silicon oxide; and based on a total mass of all elements at a first position of the electrode plate, a mass content A of element Si satisfies: A < 0.01 wt%, where the first position is a position 5 mm away from the end surface.

In this embodiment of the present application, the protective layer is arranged at least on the end surface of the electrode plate, and the protective layer includes the silicon oxide. In this way, disposition of the protective layer can reduce a risk that a short circuit is generated when the end surface overlaps an electrode of opposite polarity, thereby helping improve reliability of a battery cell. Based on a total mass of all elements at a first position of the electrode plate, a mass content A of element Si satisfies: A < 0.01 wt%. In this way, the electrode plate almost does not include the element Si at the first position, and therefore, negative impact of the element Si on cycling performance of the battery cell can be reduced. Therefore, the technical solution in the embodiments of the present application helps improve the reliability and the cycling performance of the battery cell.

In a possible implementation, based on a total mass of all elements at a second position of the electrode plate, a mass content B of the element Si satisfies: B ≤ 0.05 wt%, where the second position is a position 3 mm away from the end surface.

Based on a total mass of all elements at a third position of the electrode plate, a mass content C of the element Si satisfies: C ≤ 1.2 wt%, where the third position is a position 0.5 mm away from the end surface.

In the foregoing technical solution, as the distance to the end surface decreases, the content of the element Si gradually increases. In the foregoing technical solution, content of the element Si at the second position and at the third position is also a relatively small value, which can reduce impact on the cycling performance of the battery cell.

In a possible implementation, based on a total mass of all elements on the end surface of the electrode plate, a mass content D of the element Si satisfies: 8 wt% ≤ D ≤ 35 wt%; and optionally, 15 wt% ≤ D ≤ 30 wt%. In this way, the element Si of a particular mass content is disposed at the end surface, and the silicon oxide of a particular content is disposed at the end surface, to reduce a risk of the short circuit generated when the end surface of the electrode plate overlaps the electrode of opposite polarity.

In a possible implementation, a thickness d1 of the protective layer satisfies: 20 nm ≤ d1 ≤ 200 nm. In this way, the protective layer can have a particular shear strength, and other adverse effects caused by an excessively thick protective layer can also be reduced.

In a possible implementation, the thickness d1 of the protective layer satisfies: 80 nm ≤ d1 ≤ 170 nm. When d1 is greater than or equal to 80 nm, the protective layer has a suitable thickness to reduce the risk of the short circuit. When d1 is less than or equal to 170 nm, the thickness of the protective layer is relatively small, which can reduce negative impact caused by an excessively large thickness of the protective layer on the performance of the battery cell.

In a possible implementation, a shear strength G of the protective layer satisfies: 70 MPa ≤ G ≤ 200 MPa. In this way, the protective layer and the electrode plate have relatively strong binding strength, and a risk that the protective layer is released from the electrode plate is relatively low. In addition, it is beneficial to reducing time and temperature required for preparing the protective layer. Optionally, 100 MPa ≤ G ≤ 150 MPa. In this way, the protective layer and the electrode plate have proper binding strength, and this also helps reduce negative impact on electrical performance of the battery cell caused by preparing a protective layer having a relatively high shear strength.

In a possible implementation, the electrode plate includes a main body portion and a tab, the tab projects out of the main body portion along a first direction, and the protective layer is arranged on at least some positions of an end surface of the main body portion along the first direction and the tab. In this way, a risk of a short circuit caused by the end surface and the tab overlapping an electrode of opposite polarity can be reduced.

In a possible implementation, the protective layer is arranged on an end surface of the main body portion along a second direction, and the second direction is perpendicular to the first direction and parallel to a surface on which the electrode plate is located. In this way, the protective layer is arranged on both the end surface of the main body portion along the first direction and the end surface of the main body portion along the second direction, helping to further reduce the risk of the short circuit caused by the electrode plate overlapping the electrode of opposite polarity.

In a possible implementation, the electrode plate is a positive electrode plate, the positive electrode plate includes a positive electrode active material, and the positive electrode active material includes layered transition metal oxide.

In the foregoing technical solution, a battery prepared by selecting the foregoing positive electrode active material has a higher energy density, so that the battery can balance between high energy density and high reliability.

In a possible implementation, the layered transition metal oxide includes at least one of LiNi_{0.8}Co_{0.1}Mn_{0.1}O₂ or LiNi_{0.6}Co_{0.2}Mn_{0.2}O₂. The foregoing positive electrode active material has a relatively high Ni content and a relatively high capacity per gram, which is beneficial to preparing a battery having a relatively high energy density.

According to a second aspect, an electrode assembly is provided, including the electrode plate according to any one of the first aspect and the possible implementations thereof.

According to a third aspect, a battery cell is provided, including the electrode assembly according to the second aspect and a housing, where the housing is configured to accommodate the electrode assembly. The battery cell can balance between high reliability in good cycling performance.

According to a fourth aspect, a preparation method for a battery cell is provided, including: placing an electrode assembly in a container; feeding a gas-state silane, water vapor, and a pH regulator into the container, to obtain an electrode assembly provided with a protective layer, where the protective layer includes silicon oxide, and a general formula of the silane satisfies: R'-Si(OR)ₙ, where R' includes an organic or inorganic functional group, R includes an alkyl group, n is an integer, and 2 ≤ n ≤ 4; and extracting the electrode assembly provided with the protective layer from the container and placing the electrode assembly in a housing, to obtain the battery cell.

In this embodiment of the present application, the gas-state silane and the water vapor react on a bare metal surface of the electrode assembly, to generate the protective layer on the bare metal surface of the electrode assembly. The protective layer includes silicon oxide. In this way, risks such as a short circuit that occurs when the bare metal in the electrode assembly overlaps an electrode of opposite polarity can be reduced, thereby facilitating improving reliability of the battery cell. The reaction between the silane and water molecules can be promoted by feeding the pH regulator into the container, which helps to improve efficiency of the reaction between the silane and the water molecules, reduces time for which the electrode assembly is placed in the container, and further reduces adverse impact of infiltration of the element Si into the active material region on the cycling performance of the battery cell. The electrode assembly provided with the protective layer is extracted from the container and placed into the housing, thereby facilitating assembly of the battery cell. In addition, because the housing is not placed in the container, the protective layer is not generated inside the housing, and therefore, adverse impact of the protective layer on the battery cell can be reduced. Therefore, the battery cell obtained in the technical solution has good reliability and cycling performance.

In a possible implementation, the pH regulator includes an alkaline gas. A risk that the alkaline gas interacts with the positive electrode active material in the electrode assembly, for example, residual alkali on a surface of the positive electrode active material, is relatively low, which helps reduce an adverse effect caused on the capacity of the battery.

In a possible implementation, the alkaline gas includes at least one of ammonia, phosphine, methylamine, dimethylamine, trimethylamine, or ethylamine. The foregoing pH regulator has suitable basicity as the alkali gas, helping to improve efficiency of the reaction between the silane and the water molecules.

In a possible implementation, the pH regulator includes an acid gas. The acid gas can promote the reaction between the silane and the water molecules, helping to improve preparing efficiency of the protective layer.

In a possible implementation, the acid gas includes at least one of hydrogen fluoride, hydrogen sulfide, hydrogen chloride, or sulfur dioxide. The foregoing acid gas has suitable acidity, helping to improve the efficiency of the reaction between the silane and the water molecules.

In a possible implementation, a temperature T of the container satisfies: 45 °C ≤ T ≤ 120 °C. When the temperature T is greater than or equal to 45 °C, it is convenient to reduce a difference between a temperature the gas-state silane and the temperature of the container. When T is less than or equal to 120 °C, it is convenient to reduce adverse effects of an excessively high temperature inside the container on a separator of the electrode assembly.

In a possible implementation, 60 °C ≤ T ≤ 100 °C. In this way, it is beneficial to further reducing the difference between the temperature of the container and the temperature of the gas-state silane, and beneficial to the reaction between the silane and the water molecules.

In a possible implementation, a boiling point of the silane is less than or equal to 200°C. In this way, it is beneficial to the reaction between the silane and the water molecules at a relatively low temperature in the container.

In a possible implementation, the silane includes at least one of (H₅C₂O)₃Si-CH₂CH₂-Si(OC₂H₅)₃, (H₅C₂O)₃Si-(CH₂)₃-NH-(CH₂)₃-Si(OC₂H₅)₃, (H₅C₂O)₃Si-(CH₂)₃-S₄-(CH₂)₃-Si(OC₂H₅)₃, (H₅C₂O)₃Si-(CH₂)₃-NH-CO-NH₂, CH₂OCHCH₂-O-(CH₂)₃-Si(OCH₃)₃, (CH₃)₂-Si(OCH₃)₂, or CH₃-Si(OCH₃)₃. The foregoing substances are used as the silane for ease of hydrolysis.

In a possible implementation, the silane includes (CH₃)₂-Si(OCH₃)₂. The silane has a relatively low boiling point, so that the silane can be conveniently converted into the gas-state silane. In addition, a steric hindrance of the silane is relatively low, facilitating generation of silicon oxide.

In a possible implementation, an inlet flow rate Q1 of the gas-state silane, an inlet flow rate Q2 of the water vapor, and an inlet flow rate Q3 of the pH regulator satisfy: Q2 ≥ Q1 > Q3. In this way, it is beneficial to the reaction between the water molecules and the silane, and is also beneficial to reducing an amount of the silane.

In a possible implementation, the inlet flow rate Q1 of the gas-state silane satisfies: 0.5 L/min ≤ Q1 ≤ 1.5 L/min; and/or the inlet flow rate Q2 of the water vapor satisfies the following: 1 L/min ≤ Q2 ≤ 2 L/min; and/or the inlet flow rate Q3 of the pH regulator satisfies: 0.1 L/min ≤ Q3 ≤ 1 L/min.

By setting inlet flow rates of the gas-state silane, the water vapor, and the pH regulator, the gas-state silane, the water vapor, and the pH regulator enter the container at suitable rates, so that the gas-state silane and the water vapor react on the metal surface, facilitating generation of the protective layer. In addition, this also helps to reduce a risk that the silane infiltrates into a position of unexposed metal of the electrode assembly.

In a possible implementation, a reaction time t1 of the gas-state silane and the water vapor satisfies: 2 h ≤ t1 ≤ 8 h; and optionally, 4 h ≤ t1 ≤ 6 h. In this way, the protective layer can be generated in a relatively short time, and a risk that the protective layer is generated on the active material layer of the electrode assembly due to an excessively long reaction time is reduced, thereby helping reduce adverse effects on electrical performance such as the cycling performance of the battery cell.

In a possible implementation, a pressure P in the container satisfies: 0.09 MPa ≤ P ≤ 0.11 MPa. In this way, the protective layer can be generated under a normal pressure, to reduce preparation complexity. In addition, this also helps to reduce the risk that the silane infiltrates into the position of unexposed metal of the electrode assembly, thereby reducing impact on the cycling performance of the battery cell.

In a possible implementation, the container is in communication with an external environment. In this way, a relatively constant pressure can be maintained in the container.

In a possible implementation, the preparation method further includes: feeding a carrier gas into a storage tank storing water, to obtain the water vapor. In this way, the water vapor can be obtained by using the carrier gas, to facilitate feeding the water vapor into the container.

In a possible implementation, an inlet flow rate Q4 of the carrier gas satisfies: 0.9 L/min ≤ Q4 ≤ 2.2 L/min. In this way, it is convenient to obtain the water vapor.

In a possible implementation, the placing an electrode assembly in a container includes: placing a plurality of electrode assemblies in a bracket, where the bracket covers a surface having a largest area of the electrode assemblies; and placing the bracket loaded with the plurality of electrode assemblies in the container. In this way, a plurality of electrode assemblies can be processed in the container, which is beneficial to improving production efficiency. In addition, the bracket covers the surface having the largest area on the electrode assembly, which is further beneficial to reducing a risk that the silane and the like enter the interior of the electrode assembly.

In a possible implementation, the preparation method further includes: before the feeding a gas-state silane and water vapor into the container, feeding an inert gas into the container, to evacuate air in the container. In this way, adverse effects of the air on the reaction between the silane and the water vapor can be reduced.

In a possible implementation, the placing an electrode assembly in a container includes: connecting the electrode assembly to an end cover assembly, and placing the electrode assembly connected to the end cover assembly in the container. In this way, the electrode assembly and the end cover assembly are connected to form a whole to be processed, facilitating preparing the protective layer at a connection point of the electrode assembly and the end cover assembly.

According to a fifth aspect, a battery is provided, including the battery cell according to the third aspect, and/or a battery cell obtained according to the preparation method in any one of the fourth aspect and the possible implementations thereof.

According to a sixth aspect, a power consuming apparatus is provided, including the battery in the fifth aspect.

### BRIEF DESCRIPTION OF THE DRAWINGS

In order to provide a clearer explanation of the technical solution of the embodiments of the present application, a brief introduction will be given to the accompanying drawings required in the embodiments of the present application. It is evident that the accompanying drawings described below are only some embodiments of the present application. For ordinary technical personnel in the art, other accompanying drawings can be obtained based on the drawings without any creative effort.
FIG. 1 is a schematic diagram of a structure of an electrode plate before a tab is cut according to an embodiment of the present application;
FIG. 2 is a schematic diagram of a structure of an electrode plate after a tab is cut according to an embodiment of the present application;
FIG. 3 is a cross-section view along a direction A-A in FIG. 2;
FIG. 4 is a cross-section view along a direction B-B in FIG. 2;
FIG. 5 is a schematic diagram of a battery cell according to an embodiment of the present application;
FIG. 6 is a schematic diagram of a preparation method for a battery cell according to an embodiment of the present application;
FIG. 7 is a schematic diagram of an electrode assembly connected to an end cover assembly according to an embodiment of the present application;
FIG. 8 is a schematic diagram of a bracket on which an electrode assembly is disposed;
FIG. 9 is a schematic diagram of deposition of silane and water vapor according to an embodiment of the present application;
FIG. 10 is a schematic diagram of a device for preparing a protective layer according to an embodiment of the present application;
FIG. 11 is a schematic diagram of a battery according to an embodiment of the present application; and
FIG. 12 is a schematic diagram of a power consuming apparatus according to an embodiment of the present application.

### DETAILED DESCRIPTION

Implementations of an electrode plate, an electrode assembly, a battery cell, a preparation method therefor, a battery, a power consuming apparatus are specifically disclosed in detail below appropriately with reference to detailed descriptions of the accompanying drawings. However, there may be situations where unnecessary detailed explanations are omitted. For example, there are situations where detailed explanations of well-known matters are omitted and repeated explanations of the same structure are actually provided. Thus, the following descriptions do not become unnecessarily lengthy, which facilitates the easy comprehension of those skilled in the art. In addition, the accompanying drawings and the following explanations are provided for those skilled in the art to fully understand this application and are not intended to limit the subject matter recorded in the claims.

The "scope" disclosed in this application is limited in the form of a lower limit and an upper limit. The given scope is limited by selecting a lower limit and an upper limit, and the selected lower limit and upper limit limit the boundary of the special scope. The range defined in this way may include or exclude end values, and may be arbitrarily combined, that is, any lower limit can be combined with any upper limit to form a range. For example, if ranges of 60 to 120 and 80 to 110 are listed for a particular parameter, it is to be understood that ranges of 60 to 110 and 80 to 120 are also expected. In addition, if the minimum range values 1 and 2 are listed, and if the maximum range values 3, 4, and 5 are listed, the following ranges can all be expected: 1 to 3, 1 to 4, 1 to 5, 2 and 3, 2 to 4, and 2 to 5. In this application, unless otherwise specified, the numerical range "a to b" represents an abbreviated representation of any combination of real numbers between a and b, where a and b are both real numbers. For example, the numerical range "0 to 5" means that all real numbers between 0 and 5 are listed herein, and "0 to 5" is merely an abbreviated representation of the combination of these numbers. In addition, when a parameter is expressed as an integer ≥2, it is equivalent to disclosing that the parameter is, for example, an integer of 2, 3, 4, 5, 6, 7, 8, 9, 10, 11, 12, or the like.

Unless otherwise specified, all implementations and optional implementations of the present application may be combined to form new technical solutions.

Unless otherwise specified, all technical features and optional technical features of the present application may be combined with each other to form new technical solutions.

Unless otherwise specified, all steps in the present application may be performed in the order described or in a random order, and preferably in the order described. For example, that "the method includes step (a) and step (b)" indicates that the method may include step (a) and step (b) performed sequentially, or the method may include step (b) and step (a) performed sequentially. For example, that "the method may further include step (c)" indicates that step (c) may be added to the method in any order. For example, the method may include step (a), step (b), and step (c), may include step (a), step (c), and step (b), or may include step (c), step (a), and step (b).

Design factors in many aspects need to be simultaneously considered for development of the battery technologies, such as an energy density, a cycle life, a discharge capacity, a charging and discharging rate, and reliability. Bare metal that is exposed after the electrode plate in the battery cell is cut has a risk of overlapping with an electrode of opposite polarity or another component of the battery cell to generate a short circuit. In some processing manners, a corresponding protective layer is arranged at a position of bare metal on the electrode assembly to reduce the risk of the short circuit and improve the reliability of the battery cell. However, the foregoing processing manner has limited improvement on the cycling performance of the battery cell.

In view of this, this application provides an electrode plate. A protective layer is arranged at least on an end surface of the electrode plate. The protective layer includes silicon oxide, and a mass content of element Si at a distance from the end surface is less than 0.01 wt%. In this way, the protective layer can reduce the risk of the short circuit, and content of the element Si at a distance from the end surface is very low, thereby reducing adverse effects of the element Si on the cycling performance of the battery cell. Therefore, the battery cell in this application has high reliability and cycling performance.

### [Electrode plate]

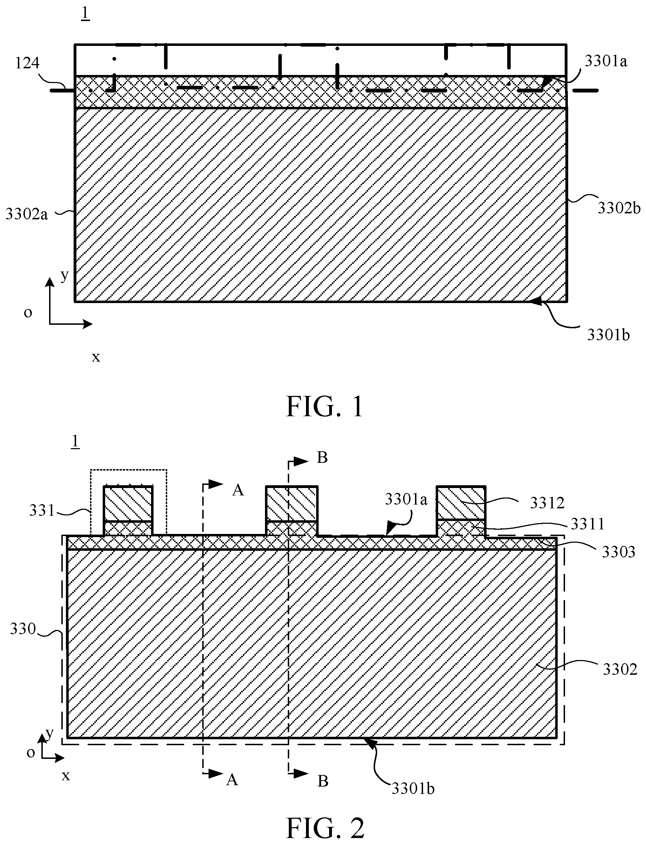

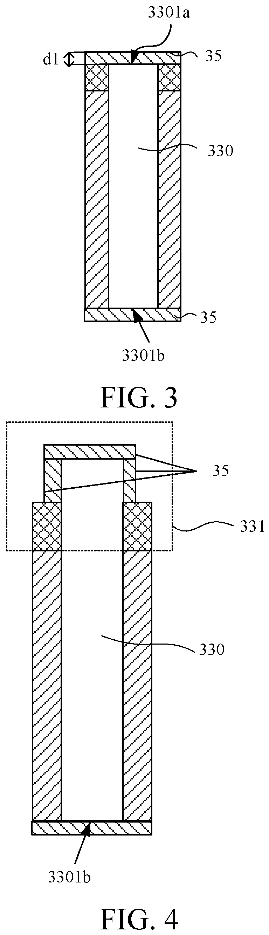

FIG. 1 is a schematic diagram of a structure of an electrode plate before a tab is cut according to an embodiment of the present application. FIG. 2 is a schematic diagram of a structure of an electrode plate after a tab is cut according to an embodiment of the present application. FIG. 3 is a cross-section view along a direction A-A in FIG. 2. FIG. 4 is a cross-section view along a direction B-B in FIG. 2.

In an embodiment of the present application, for example, with reference to FIG. 1 to FIG. 4, the protective layer 35 is arranged at least on the end surface of the electrode plate 1, and the protective layer 35 includes the silicon oxide.

The end surface of the electrode plate 1 may include any one of opposite end surfaces along a first direction (for example, a y direction in the figure) of the electrode plate 1 and opposite end surfaces along a second direction (for example, an x direction in the figure).

Two opposite end surfaces along the first direction of the electrode plate 1 may include a first end surface 3301a and a second end surface 3301b.

Two opposite end surfaces along the second direction of the electrode plate 1 may include a third end surface 3302a and a fourth end surface 3302b.

The end surface of the electrode plate 1 may be a surface formed through cutting, and after cutting, metal on the end surface is exposed. For example, as shown in FIG. 1 to FIG. 3, an end surface of the main body portion 330 along the first direction may include a first end surface 3301a and a second end surface 3301b, the first end surface 3301a may be a surface formed in a process of cutting the electrode plate along a cutting line 124 to prepare a tab 331, and the second end surface 3301b may be a surface generated through cutting in a process of slitting the electrode plate 1. Slitting may refer to a process in which a large electrode plate is cut into a plurality of small electrode plates 1.

In an example, the protective layer 35 is arranged on both the end surface along the first direction and the end surface along the second direction.

In another example, as shown in FIG. 1 to FIG. 4, the protective layer 35 is arranged on the end surface along the first direction of the electrode plate 1, and the protective layer 35 is not arranged on the end surface along the second direction of the electrode plate 1.

In still another example, the protective layer 35 is arranged on an end surface (the first end surface 3301a) of the electrode plate 1 close to an end of the tab along the first direction, and the protective layer 35 is arranged on an end surface (the second end surface 3301b) away from the end of the tab; and the protective layer 35 is not arranged on the end surface along the second direction of the electrode plate 1.

The protective layer 35 includes silicon oxide, where the silicon oxide may have the following structure: -Si-O-Si-. The silicon oxide does not easily swell when immersed in an electrolyte, and does not easily fall off in long-term usage of the battery cell 3.

The protective layer 35 has specific insulation performance, and can reduce a risk that a short circuit is generated when the end surface overlaps an electrode of opposite polarity, thereby helping improve reliability of the battery cell.

Based on a total mass of all elements at a first position of the electrode plate 1, a mass content A of element Si satisfies: A < 0.01 wt%, where the first position is a position 5 mm away from the end surface.

The first position may be a position on the electrode plate 1 that is 5 mm away from the end surface along any direction.

In an example, the first position is a position on the electrode plate 1 that is 5 mm away from the second end surface 3301b along the first direction (the y direction in the figure).

In another example, the first position is a position on the electrode plate 1 that is 5 mm away from the third end surface 3302a along the second direction (the x direction in the figure).

The first position of the electrode plate 1 includes a plurality of elements forming a material of the electrode plate 1. For example, for a positive electrode plate, a first position of the positive electrode plate includes an element such as element Al forming a material of a positive electrode current collector, an element forming a material of a positive electrode film layer, and element Si that may infiltrate into the positive electrode film layer. For a negative electrode plate, a first position of the negative electrode plate includes an element such as element Cu forming a material of a negative electrode current collector, an element forming a material of a negative electrode film layer, and element Si that may infiltrate into the negative electrode film layer.

In a process of preparing the protective layer 35, raw materials, for example, silane and water, for preparing the protective layer 35 deposit and react on the electrode plate 1. The mass content of the element Si may reflect a degree of infiltration or attachment of the silane to the electrode plate 1, or may reflect a content of the silicon oxide on the electrode plate 1.

The silicon oxide or the silicon element affects the electrical conductivity performance of the electrode plate, and consequently, affects the electrical performance of the battery cell, for example, affect a capacity retention rate, a power, and a resistance of the battery cell.

When the mass content of the element Si is less than 0.01 wt%, it may be approximately considered that the first position does not include silicon oxide or that the silane does not infiltrate into the first position. In this way, there is a relatively low risk of providing the silicon oxide or the silane on a region of unexposed metal on the electrode plate 1, and therefore, there is a relatively low impact on the electrical performance of the battery cell, which helps reduce the impact on the cycling performance of the battery cell.

In this embodiment of the present application, the protective layer 35 is arranged at least on the end surface of the electrode plate 1, and the protective layer 35 includes the silicon oxide. Disposition of the protective layer 35 can reduce a short-circuit risk of the battery cell, thereby facilitating improving reliability of the battery cell. At the first position of the electrode plate 1, the mass content A of the element Si satisfies: A < 0.01 wt%. In this way, the battery cell has relatively high cycling performance. Therefore, the technical solution in the embodiments of the present application helps improve the reliability and the cycling performance of the battery cell.

In some embodiments, based on a total mass of all elements at a second position of the electrode plate 1, a mass content B of the element Si satisfies: B ≤ 0.05 wt%, where the second position is a position 3 mm away from the end surface.

In some embodiments, based on a total mass of all elements at a third position of the electrode plate 1, a mass content C of the element Si satisfies: C ≤ 1.2 wt%, where the third position is a position 0.5 mm away from the end surface.

B may be 0.05 wt%, 0.02 wt%, 0.01 wt%, 0 wt%, or any value within the foregoing range, and C may be 1.2 wt%, 1.1 wt%, 1 wt%, 0.5 wt%, 0 wt%, or any value within the foregoing range.

The second position may be a position on the electrode plate 1 that is 3 mm away from the end surface along any direction; and the third position may be a position on the electrode plate 1 that is 0.5 mm away from the end surface along any direction.

In an example, the second position is a position that is 3 mm away from the second end surface 3301b along the first direction, for example, the y direction in FIG. 1.

In an example, the third position is a position that is 0.5 mm away from the second end surface 3301b along the first direction, for example, the y direction in FIG. 1.

In the foregoing technical solution, as the distance to the end surface decreases, the content of the element Si gradually increases. In the foregoing technical solution, content of the element Si at the second position and at the third position is also a relatively small value. This can reflect that the content of the element Si at a position of unexposed metal on the electrode plate 1 is relatively small, and can reduce impact on the cycling performance of the battery cell.

In some embodiments, based on a total mass of all elements on the end surface of the electrode plate, a mass content D of the element Si satisfies: 8 wt% ≤ D ≤ 35 wt%; and optionally, 15 wt% ≤ D ≤ 30 wt%. In this way, the element Si of a particular mass content is disposed at the end surface, and the silicon oxide of a particular content is disposed at the end surface, to reduce a risk of the short circuit generated when the end surface of the electrode plate 1 overlaps the electrode of opposite polarity.

D may be 8 wt%, 10 wt%, 15 wt%, 20 wt%, 30 wt%, 35 wt%, or any value within the foregoing range.

In some embodiments, a thickness d1 of the protective layer 35 satisfies: 20 nm ≤ d1 ≤ 200 nm.

The thickness d1 of the protective layer 35 may be 190 nm, 160 nm, 100 nm, 50 nm, 20 nm, or any value within the foregoing range. The thickness d1 of the protective layer 35 may be an average thickness of the protective layer 35. For example, measurement is performed at a plurality of positions on the end surface, and an average value of a plurality of pieces of data is used as the thickness of the end surface.

At different positions, for example, at the first end surface 3301a and the second end surface 3301b, the protective layers 35 have the same or approximately the same thickness.

When d1 is greater than or equal to 20 nm, the protective layer 35 has a suitable thickness to reduce the risk of the short circuit, and the protective layer 35 has a specific shear strength, and has a low risk of falling off. When d1 is less than or equal to 200 nm, negative impact caused by an excessively large thickness of the protective layer 35 on the performance of the battery cell 3.

In some embodiments, the thickness d1 of the protective layer 35 satisfies: 80 nm ≤ d1 ≤ 170 nm. d1 may be 80 nm, 100 nm, 120 nm, 160 nm, 170 nm, or any value within the foregoing range.

When d1 is greater than or equal to 80 nm, the protective layer 35 has a suitable thickness to reduce the risk of the short circuit. When d1 is less than or equal to 170 nm, the thickness of the protective layer 35 is relatively small, which can reduce negative impact caused by an excessively large thickness of the protective layer 35 on the performance of the battery cell 3.

In some embodiments, a shear strength G of the protective layer 35 satisfies: 70 MPa ≤ G ≤ 200 MPa.

For example, G may be 70 MPa, 80 MPa, 85 MPa, 90 MPa, 96 MPa, 100 MPa, 120 MPa, 150 MPa, 170 MPa, 200 MPa, or any value within the foregoing range.

The shear strength of the protective layer 35 is related to the thickness of the protective layer 35. In the embodiments of the present application, a larger thickness of the protective layer 35 indicates a higher shear strength of the protective layer 35.

The shear strength of the protective layer 35 can reflect a binding strength between the protective layer 35 and the electrode plate 1. The higher shear strength of the protective layer 35 indicates a stronger bond between the protective layer 35 and the electrode plate 1 and a lower risk that the protective layer 35 falls off from the electrode plate 1. In addition, in long-term usage of the battery cell 3, a risk that the protective layer 35 swells when immersed in an electrolyte is relatively low, and the protective layer 35 does not easily fall off, which is beneficial to improving the reliability of the battery cell 3.

When the shear strength of the protective layer 35 is greater than or equal to 70 MPa, a risk that the protective layer 35 falls off from the electrode plate 1 is relatively low. When the shear strength of the protective layer 35 is less than or equal to 200 MPa, it is convenient to prepare the protective layer 35, and it helps to reduce a time required for preparing the protective layer 35 and a temperature required for preparing the protective layer 35.

The protective layer 35 having a shear strength within the foregoing range does not easily fall off from the electrode plate 1, so that the battery cell including the electrode plate 1 has relatively long service life, and the battery cell is applicable to electric vehicles.

For a method for testing the shear strength of the protective layer 35, refer to some content of test methods below.

In some embodiments, 100 MPa ≤ G ≤ 150 MPa. G may be 100 MPa, 115 MPa, 130 MPa, 135 MPa, 150 MPa, or any value within the foregoing range.

In the embodiments, 100 MPa ≤ G ≤ 150 MPa, the protective layer 35 and the electrode plate 1 have proper binding strength, and this also helps reduce negative impact on electrical performance of the battery cell 3 caused by preparing a protective layer 35 having a relatively high shear strength.

In some embodiments, the metal on the end surface is bonded with the silicon oxide in the protective layer 35 through a chemical bond. Specifically, the metal is bonded with the silicon oxide through a covalent bond.

In an example, the bond between the metal and the silicon oxide is represented in the following manner: Me-Si-O-Si, where Me represents the metal.

In an example, Me is aluminum. In another example, Me is copper.

The shear strength of the protective layer 35 is related to a connection manner between the protective layer 35 and the bare metal of the electrode plate 1. In the embodiments, a binding force between the protective layer 35 and the end surface 3301 is relatively strong, and the protective layer 35 does not easily fall off.

In some embodiments, the electrode plate 1 includes a main body portion 330 and a tab 331, the tab 331 projects out of the main body portion 330 along a first direction, and the protective layer 35 is arranged on at least some positions of the end surface 3301 of the main body portion 330 along the first direction and the tab 331.

The first direction is a direction in which the tab 331 projects out of the main body portion 330. For example, as shown in FIG. 2, the first direction is a y direction.

A protective layer 35 is arranged at least on some positions of the tab 331. It may be understood that, the protective layer 35 is arranged at some positions of the tab 331, or the protective layer 35 is arranged at all positions of the tab 331. The at least some positions of the tab 331 may refer to positions of bare metal of the tab 331.

In an example, as shown in FIG. 2, the tab 331 may include a first part 3311 and a second part 3312. The first part 3311 is connected to the second part 3312, and the first part 3311 is closer to the main body portion 330 than the second part 3312 is. The main body portion 330 includes a first region 3302 and a second region 3303 connected to each other, and the second region 3303 is closer to the tab 331 than the first region 3302 is. The first part 3311 of the tab 331 and the second region 3303 of the main body portion 330 are coated with an insulation material, the second part 3312 of the tab 331 is bare aluminum foil, and the first region 3302 of the main body portion 330 is coated with an active material. The first part 3311 is not provided with the protective layer 35, and the second part 3312 is provided with the protective layer 35.

In another example, all regions of the main body portion 330 are coated with the active material, all regions of the tab 331 are bare aluminum foil, and all regions of the tab 331 are provided with the protective layer 35.

In some embodiments, the first position is a position 5 mm away from the end surface of the main body portion 330 along the first direction. For example, the first position is a position 5 mm away from the second end surface 3301b along the first direction. Si content at the first position facilitates reflecting an infiltration status of the silicon element, thereby reflecting a change in the electrical performance of the battery cell to some extent.

In some embodiments, the metal in the tab 331 is bonded with the silicon oxide in the protective layer 35 through a chemical bond. In this way, a risk of a short circuit generated when the tab 331 overlaps an electrode of opposite polarity can be reduced.

In some embodiments, the protective layer 35 is arranged on an end surface of the main body portion 330 along a second direction, and the second direction is perpendicular to the first direction and parallel to a surface on which the electrode plate 1 is located. For example, the second direction is the x direction in FIG. 1.

In the embodiments, the protective layer 35 is arranged on both the end surface of the main body portion 330 along the second direction and the end surface of the main body portion 330 along the first direction, helping to further reduce the risk of the short circuit caused by the electrode plate 1 overlapping the electrode of opposite polarity.

In some embodiments, the electrode plate is a positive electrode plate, the positive electrode plate includes a positive electrode active material, and the positive electrode active material includes layered transition metal oxide. The battery prepared by selecting the foregoing positive electrode active material has a higher energy density, so that the battery can balance between high energy density and high reliability.

The layered transition metal oxide may include a ternary material, lithium cobalt oxide, a lithium-rich manganese-based material, and the like.

In an example, a formula of the layered transition metal oxide includes: Liₓ(NiₐCo_{b}Mn_{c})_{1-d}M_{d}O_{2-y}N_{y}, M includes at least one of Mg, Zr, Al, B, Ta, Mo, W, Nb, Sb, and La, N includes at least one of F, S, and P, 0.6 ≤ a < 1, 0 < b < 0.4, 0 < c < 0.4, a + b + c = 1, 0 ≤ d < 1, 0.2 ≤ x ≤ 1.2, and 0 ≤ y < 2.

a may be 0.6, 0.7, 0.8, 0.9, or any value within the foregoing range, b may be 0.1, 0.2, 0.3, or any value within the foregoing range, c may be 0.1, 0.2, 0.3, or any value within the foregoing range, d may be 0, 0.1, 0.6, 0.6, 0.8, or any value within the foregoing range, x may be 0.2, 0.5, 1, 1.2, or any value within the foregoing range, and y may be 0, 0.5, 1, 1.5, 2, or any value within the foregoing range.

When d is greater than 0, the layered transition metal oxide includes element M, and the layered transition metal oxide can have higher stability. When d is 0, the layered transition metal oxide does not include the element M.

It may be understood that, a position of M ions in the layered transition metal oxide structure may replace a position of a part of the transition metal. For example, when the layered transition metal oxide is a nickel-cobalt-manganese ternary material, the M ions may replace some of manganese sites, nickel sites, or cobalt sites.

When y = 0, the layered transition metal oxide does not include element N. It may be understood that, a position of N ions in the layered transition metal oxide structure may replace a position of a part of O.

During charging and discharging of a battery, Li is deintercalated and consumed. When the battery is discharged to different states, a mol content of Li differs. The foregoing limitation on x includes mol contents of Li in different charging and discharging states of the battery (where a voltage of the battery usually ranges from 2 V to 5 V).

In the foregoing technical solution, the positive electrode active material satisfying the foregoing formula has a relatively high nickel content, and the positive electrode active material has a relatively high capacity per gram.

In some embodiments, the layered transition metal oxide includes at least one of LiNi_{0.8}Co_{0.1}Mn_{0.1}O₂ or LiNi_{0.6}Co_{0.2}Mn_{0.2}O₂. The foregoing positive electrode active material has a relatively high capacity per gram, which is beneficial to preparing a battery having a relatively high energy density.

The electrode plates 1 may be a positive electrode plate, or may be a negative electrode plate. In an example, the positive electrode plate and the negative electrode plate both have the structure described for the electrode plate 1.

### [Positive electrode plate]

The positive electrode plate includes a positive electrode current collector and a positive electrode film layer disposed on the positive electrode current collector.

The positive electrode current collector may be metal foil, or may be a composite current collector. For example, the positive electrode current collector may be aluminum foil.

The composite current collector may include a polymer material substrate and a metal layer formed on at least one surface of the polymer material substrate. The composite current collector may be formed by forming a metal material (aluminum, an aluminum alloy, nickel, a nickel alloy, titanium, a titanium alloy, silver, a silver alloy, or the like) on a polymer material substrate (for example, a substrate of polypropylene (PP), polyethylene terephthalate (PET), polybutylene terephthalate (PBT), polystyrene (PS), or polyethylene (PE)).

The positive electrode film layer includes a positive electrode active material. The positive electrode active material may be a positive electrode active material used in a battery and well known in the art. For example, the positive electrode active material is lithium iron phosphate, a ternary material, or a lithium-rich manganese-based material.

The positive electrode film layer optionally includes a binder. As an example, the binder may include at least one of polyvinylidene fluoride (PVDF), polytetrafluoroethylene (PTFE), vinylidene fluoride-tetrafluoroethylene-propylene terpolymer, vinylidene fluoride-hexafluoropropylene-tetrafluoroethylene terpolymer, tetrafluoroethylene-hexafluoropropylene copolymer, and fluorine-containing acrylate resin.

The positive electrode film layer optionally includes a conductive agent. The conductive agent may include at least one of superconducting carbon, acetylene black, carbon black, Ketjen black, carbon dots, carbon nanotubes, graphene, and carbon nanofibers.

### [Negative electrode plate]

The negative electrode plate includes a negative electrode current collector and a negative electrode film layer disposed on the negative electrode current collector.

The negative electrode current collector may be metal foil, or may be a composite current collector. The negative electrode current collector may be copper foil. The composite current collector may be formed by forming a metal material (such as copper, a copper alloy, nickel, a nickel alloy, titanium, a titanium alloy, silver, and a silver alloy) on a polymer material substrate (such as a substrate of polypropylene (PP), polyethylene terephthalate (PET), polybutylene terephthalate (PBT), polystyrene (PS), or polyethylene (PE)).

The negative electrode film layer includes a negative electrode active material. The negative electrode active material may be a negative electrode active material used in a battery and well known in the art. In an example, the negative electrode active material may include at least one of the following materials: artificial graphite, natural graphite, soft carbon, hard carbon, a silicon-based material, a tin-based material and lithium titanate, etc. The silicon-based material may include at least one of elemental silicon, a silicon-oxygen compound, a silicon-carbon composite, a silicon-nitrogen composite, and a silicon alloy. The tin-based material may include at least one of elemental tin, a tin-oxide compound, and a tin alloy. However, the present application is not limited to these materials, and other conventional materials that can be used as negative electrode active materials for batteries can also be used. These negative electrode active materials may be used alone or in combination of two or more thereof.

In an example, the negative electrode active material is a carbon material.

The negative electrode film layer optionally includes a conductive agent. The conductive agent may include at least one of superconducting carbon, acetylene black, carbon black, Ketjen black, carbon dots, carbon nanotubes, graphene, and carbon nanofibers.

### [Electrolyte]

The electrolyte plays a role in conducting ions between the positive electrode plate and the negative electrode plate. A type of the electrolyte is not specifically limited in this embodiment of the present application, and may be selected based on requirements. For example, the electrolyte may be liquid, gelled, or all solid.

In some embodiments, the electrolyte is an electrolyte solution. The electrolytic solution includes an electrolyte salt and a solvent.

The electrolyte salt may include at least one of lithium hexafluorophosphate, lithium tetrafluoroborate, lithium perchlorate, lithium hexafluoroborate, lithium bis(fluorosulfonyl)imide, lithium bis-trifluoromethanesulfonimide, lithium trifluoromethanesulfonate, lithium difluorophosphate, lithium difluorooxalatoborate, lithium bisoxalatoborate, lithium difluorobisoxalate phosphate, and lithium tetrafluoro oxalate phosphate.

The solvent may include at least one of ethylene carbonate, propylene carbonate, ethyl methyl carbonate, diethyl carbonate, dimethyl carbonate, dipropyl carbonate, methyl propyl carbonate, ethyl propyl carbonate, butylene carbonate, fluoroethylene carbonate, methyl formate, methyl acetate, ethyl acetate, propyl acetate, methyl propionate, ethyl propionate, propyl propionate, methyl butyrate, ethyl butyrate, 1,4-butyrolactone, sulfolane, dimethyl sulfone, methyl ethyl sulfoxide, and diethyl sulfone.

The electrolyte may optionally include a negative electrode film forming additive and a positive electrode film forming additive, and may further include performance additives that can improve certain performance of the battery, such as a performance additive that improves overcharge performance of the battery, and a performance additive that improves battery performance at a high temperature or low temperature.

### [Separator]

The separator is used for separating the positive electrode plate and the negative electrode plate. A type of the separator is not particularly limited in this embodiment of the present application, and any well-known separator with a porous structure having good chemical stability and mechanical stability may be selected.

A material of the separator may include at least one of glass fiber, non-woven fabric, polyethylene, polypropylene, and polyvinylidene fluoride. The separator may be a single-layer film or a multilayer composite film without special limitations. When the separator is a multilayer composite film, materials of the layers may be the same or different without special limitations.

### [Electrode assembly]

An embodiment of the present application provides an electrode assembly, where the electrode assembly includes the electrode plate 1 according to any one of the foregoing embodiments.

An electrode assembly may be manufactured by using a positive electrode plate, a negative electrode plate, and a separator through a winding process or a laminating process. The positive electrode plate and the negative electrode plate may have the structure of the electrode plate 1.

### [Battery cell]

FIG. 4 is a schematic diagram of a structure of a battery cell according to an embodiment of the present application. For example, as shown in FIG. 4, the battery cell 3 includes a housing 31, an end cover assembly 32, and an electrode assembly 33.

The housing 31 is configured to accommodate the electrode assembly 33, and a shape of the housing 31 may be set based on a shape of the electrode assembly 33. One or more electrode assemblies may be accommodated in the housing 31. For example, as shown in FIG. 4, four electrode assemblies 33 are accommodated in the housing 31. A material of the housing 31 may be metal such as copper and aluminum.

The end cover assembly 32 is configured to cover the housing 31, to encapsulate the electrode assembly 33. The end cover assembly 32 is connected to the electrode assembly 33. The end cover assembly 32 may be directly connected to the electrode assembly 33, or may be indirectly connected to the electrode assembly 33.

In an example, as shown in FIG. 4, the electrode assembly 33 is formed by winding a positive electrode plate, a negative electrode plate, and a separator located between the positive electrode plate and the negative electrode plate.

The end cover assembly 32 is connected to the electrode assembly 33. In an example, the end cover assembly 32 is soldered to a tab portion 33a of the electrode assembly 33 through a current collecting member 34. The tab portion 33a in the electrode assembly 33 may be formed by tabs 331 of a plurality of electrode plates 1 stacked together, and the current collecting member 34 may be made of a metal, for example, copper or aluminum.

The end cover assembly 32 includes an electrode terminal 322. For example, as shown in FIG. 4, the end cover assembly 32 includes two electrode terminals 322, where one thereof is a positive electrode terminal, and the other one is a negative electrode terminal. One current collecting member 34 is configured to connect a positive electrode tab portion to the positive electrode terminal, and the other current collecting member 34 is configured to connect a negative electrode tab portion to the negative electrode terminal.

In some embodiments, a shape of the battery cell 3 may be cylindrical, square, or any other shape. The battery cell 3 may be a lithium-ion battery, a lithium-sulfur battery, a sodium-ion battery, a magnesium-ion battery, or the like. The battery cell 3 may be the smallest structural unit of a battery.

In some embodiments, the battery cell 3 may be assembled into a battery module, the number of battery cells 3 contained in the battery module may be one or more, and the specific number may be selected according to the application and capacity of the battery module.

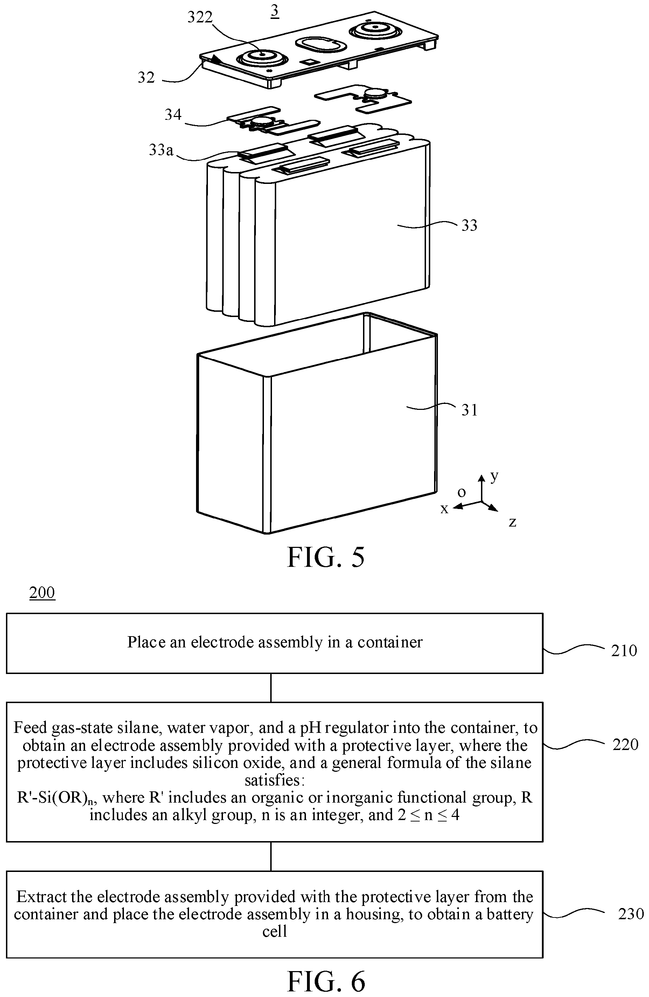

Implementations of the electrode plate and the battery cell are described above with reference to FIG. 1 to FIG. 5. A preparation method for a battery cell is described below with reference to FIG. 6. For similar descriptions, refer to the descriptions of the implementations of the electrode plate and the battery cell, and details are not described herein again.

### [Preparation method for a battery cell]

FIG. 6 is a schematic diagram of a preparation method for a battery cell according to an embodiment of the present application. For example, as shown in FIG. 6, the preparation method 200 for a battery cell includes the following steps.

Step 210: Place an electrode assembly 33 in a container.

Optionally, the electrode assembly 33 includes a main body portion 330 and a tab 331, and the tab 331 projects out of the main body portion 330 along the first direction.

The electrode assembly 33 may be prepared by using a positive electrode plate, a separator, and a negative electrode plate in a winding manner or in a stacking manner.

In step 210, only a separate electrode assembly 33 may be placed in the container, or the tab portion 33a of the electrode assembly 33 and the end cover assembly 32 may be first soldered to each other by using the current collecting member 34, so that the electrode assembly 33 and the end cover assembly 32 form one component, and then the component is placed in the container.

The container may be in communication with an external environment. For example, the container is in communication with a first connection member, so that gas can be fed into the container through the first connection member. For another example, the container may further evacuate the gas in the container through a second connection member.

In an example, the container evacuates the gas in the container through the second connection member. The second connection member may be provided with a special element, so that the gas in the container can be vented to the external environment through the second connection member, but gas in the external environment does not enter the container through the second connection member.

Step 220: Feed gas-state silane, water vapor, and a pH regulator into the container, to obtain an electrode assembly provided with a protective layer 35, where the protective layer 35 includes silicon oxide, and a general formula of the silane satisfies: R'-Si(OR)ₙ, where R' includes an organic or inorganic functional group, R includes an alkyl group, n is an integer, and 2 ≤ n ≤ 4.

It is convenient for the gas-state silane and the water vapor to be fed into the container, thereby facilitating a reaction between the silane and the water molecules.

The pH regulator may be gas. In this way, after the pH regulator enters the container, the reaction between the silane and the water molecules is promoted. The reaction between the silane and the water molecules can be promoted by feeding the pH regulator into the container, which helps to improve efficiency of the reaction between the silane and the water molecules, and helps reduce time for which the electrode assembly 33 is placed in the container, thereby reducing a risk that the silane infiltrates into a position of unexposed metal of the electrode assembly 33 (for example, a region on which the active material is disposed on the electrode plate), and reducing a risk of generating silicon oxide at the position of unexposed metal of the electrode assembly 33, so that adverse effects on the cycling performance of the battery cell are reduced.

n may be 2, 3, or 4; R includes an alkyl group, for example, R may be a methyl group or an ethyl group; and R' includes an organic or inorganic functional group, for example, R' may include an amino group or a methyl group. In an example, n is 3.

In the silane, -(OR) group is a group that can be hydrolyzed, so that the silane can be hydrolyzed to generate -Si-OH group. The end surface 3301 of the main body portion 330 and at least some surfaces of the tab 331 have bare metal. The -Si-H group may be combined with the metal, and the -Si-H groups may be cross-linked on the metal surface, to form the protective layer 35. The reaction between the silane and the water vapor on the metal surface may be roughly divided into the following three steps.
(1) Silane hydrolysis: -Si-OR+H₂O → -Si-OH+ROH;
(2) Attachment to a metal surface: -Si-OH+Me-OH → Me-O-Si-+H₂O, where Me represents the metal; and
(3) Crosslinking to form the protective layer: -Si-OH+HO-Si- → -Si-O-Si-+H₂O.

After being hydrolyzed, the silane is attached to the metal surface by means of a reaction between the -Si-OH group of the silane and the Me-OH group on the metal surface, the silane forms Si-O-Me on a metal interface, a force of a covalent bond between Si-O and Me is relatively strong, and the bond between the silane and the metal is relatively strong. In addition, remaining silane molecules form a protective layer of a three-dimensional network structure on the metal surface by means of a polycondensation reaction between the -Si-OH groups.

Before the gas-state silane is fed into the container, the silane may be first gasified outside the container (for example, in an additional storage tank). Similarly, before the water vapor is fed into the container, the water may be first vaporized outside the container.

The gas-state silane and the water vapor are fed into the container. In this way, mixing of the silane and the water vapor is facilitated, thereby facilitating the reaction to be performed.

In step 220, first, the gas-state silane may be fed, then, the water vapor may be fed, and then, the pH regulator may be passed; or the water vapor may be first fed, then the gas-state silane is fed, and then the pH regulator is fed; or the gas-state silane, the water vapor, and the pH regulator may be simultaneous fed.

In an example, the silane, the water vapor, and the pH regulator are respectively stored in different storage tanks. Valves are disposed between the storage tanks and the container. First, a valve of a storage tank storing the silane is opened, to feed the gas-state silane into the container. Subsequently, a valve of a storage tank storing the water vapor is opened, to feed the water vapor into the container. Then, a valve of a storage tank storing the pH regulator is opened, to feed the pH regulator into the container.

After the reaction is performed for a period of time, the protective layer 35 may be formed on the metal surface. In step 220, the protective layer 35 may be generated on the end surface 3301 of the main body portion 330, a surface of bare metal on the tab 331, a surface of bare metal on the end cover assembly 32, and a surface of bare metal on a connection position between the end cover assembly 32 and the electrode assembly 33.

Step 230: Extract the electrode assembly 33 provided with the protective layer 35 from the container and placing the electrode assembly 33 in a housing 31, to obtain a battery cell 3.

After the protective layer 35 having a particular thickness is generated, the container may be cooled, and the electrode assembly 33 provided with the protective layer 35 is extracted. Then, the electrode assembly 33 is placed into the housing 31, and the end cover assembly 32 is connected to the housing 31, to obtain the battery cell 3.

In the embodiments of the present application, the gas-state silane and the water vapor react on a bare metal surface of the electrode assembly 33, to generate the protective layer 35 on the bare metal surface of the electrode assembly 33. The protective layer 35 includes silicon oxide. In this way, risks such as a short circuit that occurs when the bare metal in the electrode assembly 33 overlaps an electrode of opposite polarity can be reduced, thereby facilitating improving reliability of the battery cell 3. The reaction between the silane and water molecules can be promoted by feeding the pH regulator into the container, which helps to improve efficiency of the reaction between the silane and the water molecules, reduces time for which the electrode assembly is placed in the container, and reduces a risk of generating silicon oxide at a position of unexposed metal of the electrode assembly, thereby reducing impact on the cycling performance of the battery cell. The electrode assembly 33 provided with the protective layer 35 is extracted from the container and placed into the housing 31, thereby facilitating assembly of the battery cell 3. In addition, because the housing 31 is not placed in the container, the protective layer 35 is not generated inside the housing, and therefore, adverse impact of the protective layer 35 on the battery cell can be reduced. Therefore, the battery cell 3 obtained in the technical solution has good reliability and cycling performance.

The preparation method for a battery cell in the embodiments of the present application does not use a process of vacuuming the container. In this way, complexity of operations can be reduced, and this helps to reduce a risk that the silane or the like infiltrates into or is attached to the active material layer of the electrode assembly 33, so that adverse effects on electrical performance (for example, the cycling performance, a power, or a resistance) of the battery cell 3 are reduced.

The silane has relatively high reliability, and has a very low risk of exploding in a closed container. By adding the silane into the container, the preparation method for a battery cell has relatively high reliability. In addition, a requirement on conditions inside the container is relatively low, which helps reduce complexity of the preparation method.

In some embodiments, before step 210, plasma surface treatment (PLASMA) is not performed on the electrode assembly 33. Because the pH regulator is added, the efficiency of the reaction between the silane and the water molecules is improved, the protective layer 35 may have a particular thickness, and the protective layer 35 has a particular binding strength with the metal. Therefore, the protective layer 35 does not easily fall off after being immersed in an electrolyte. In addition, steps of the plasma surface treatment are omitted, and this is also beneficial to reducing complexity of the process and saving costs.

In some embodiments, the pH regulator includes an acid gas or an alkaline gas. The acid gas or the alkaline gas can promote hydrolysis of the silane, thereby helping reduce time of the reaction between the silane and the water molecules. The alkaline gas is selected as the pH regulator, and the silane is hydrolyzed in an alkaline atmosphere, helping to improve efficiency of the reaction between the silane and the water molecules.

In some embodiments, the acid gas may include a gas such as HF, H₂S, HCl, and SO₂.

In some embodiments, the pH regulator includes an alkaline gas. An impact of the alkaline gas on the electrode assembly 33 is relatively small. For example, the alkaline gas does not react with a material in the electrode plate, which can reduce an impact on the active material. In a possible example, in comparison with the acid gas, the alkaline gas has a smaller risk of reaction with residual alkali (for example, lithium hydroxide or lithium carbonate) on the surface of the ternary material in the positive electrode plate, so that a risk that Li inside the ternary material is extracted to the surface of the ternary material is relatively small, a risk of loss of active lithium is relatively small, and the impact on a capacity and first cycle efficiency of the battery is relatively small.

In some embodiments, the alkaline gas may include at least one of ammonia, phosphine, methylamine, dimethylamine, trimethylamine, or ethylamine. The foregoing pH regulator has suitable basicity as the alkali gas, helping to improve efficiency of the reaction between the silane and the water molecules.

In an example, methylamine is selected as the alkaline gas.

In some embodiments, a temperature T of the container satisfies: 45 °C ≤ T ≤ 120 °C.

T may be 45 °C, 60 °C, 80 °C, 100 °C, 120 °C, or any value within the foregoing range.

The temperature T of the container may refer to a temperature inside the container, and the electrode assembly placed inside the container may have a temperature the same as that of the container. In an example, after the electrode assembly 33 connected to the end cover assembly 32 is placed into the container, the temperature of the container is increased to the temperature T.

A thickness of the protective layer 35 is related to the temperature of the container. A higher temperature of the container is more beneficial to the hydrolysis of the silane, and further, is more beneficial to generation of a thicker protective layer 35.

When the temperature T is greater than or equal to 45 °C, it is convenient to reduce a difference between a temperature the gas-state silane and the temperature of the container. When T is less than or equal to 120°C, it is convenient to reduce adverse effects of an excessively high temperature inside the container on a separator of the electrode assembly.

In some embodiments, 60 °C ≤ T ≤ 100 °C. In this way, the temperature range not only helps to further reduce a temperature difference between the temperature of the container and the temperature of the gas-state silane, but also helps to further reduce the temperature of the container, and reduce adverse effects of an excessively high temperature inside the container on the separator of the electrode assembly.

The gas-state silane, the water vapor, the pH regulator, and the container may have the same temperature, or may have different temperatures.

In some embodiments, the gas-state silane, the water vapor, and the pH regulator may be directly fed into the container, and the temperature in the container may be adjusted to a vaporization temperature of the silane, to reduce the temperature difference between the gas-state silane, the water vapor, and the container. For example, silane with a relatively low gasification temperature may be selected.

In some embodiments, the silane may be heated to a first temperature T1, and a carrier gas is fed into the storage tank in which the silane is stored, to obtain the gas-state silane; the water may be heated to a second temperature T2, and a carrier gas is fed into the storage tank in which the water is stored, to obtain the water vapor; and the gas-state silane and the water vapor mixed with the carrier gas, and an alkaline gas are fed into the container, to obtain the electrode assembly provided with the protective layer.

Disposition of the carrier gas facilitates feeding the gas-state silane and the water vapor into the container by using the carrier gas. It may be understood that, the gas-state silane and the carrier gas, and the water vapor and the carrier gas are fed into the container together.

In some embodiments, the carrier gas includes at least one of nitrogen, argon, carbon dioxide, and helium; and optionally, the carrier gas includes nitrogen. The carrier gas does not react with the silane and the water vapor, so that adverse effects on the reaction between the silane and the water vapor can be reduced.

In some embodiments, R includes methyl. When R is a methyl group, a steric hindrance can be reduced, cross-linking between -Si-OH and -Si-OH is facilitated, and generation of the silicon oxide is facilitated. In addition, R is the methyl group, and the silane has a relatively low boiling point, which makes it convenient to change the silane into the gas-state silane.

In some embodiments, a boiling point of the silane is less than or equal to 200°C.

In this way, the silane can be converted into the gas-state silane at or below a temperature of 200°C, thereby helping to save energy. In addition, the temperature of the container may also be set to 200°C or below, which facilitates the reaction between the silane and the water molecules at a relatively low temperature.

In some embodiments, the silane includes at least one of (H₅C₂O)₃Si-CH₂CH₂-Si(OC₂H₅)₃, (H₅C₂O)₃Si-(CH₂)₃-NH-(CH₂)₃-Si(OC₂H₅)₃, (H₅C₂O)₃Si-(CH₂)₃-S₄-(CH₂)₃-Si(OC₂H₅)₃, (H₅C₂O)₃Si-(CH₂)₃-NH-CO-NH₂, CH₂OCHCH₂-O-(CH₂)₃-Si(OCH₃)₃, (CH₃)₂-Si(OCH₃)₂, or CH₃-Si(OCH₃)₃. The foregoing substances are used as the silane for ease of hydrolysis.

In some embodiments, the silane includes (CH₃)₂-Si(OCH₃)₂. The silane has a relatively low boiling point, so that the silane can be conveniently converted into the gas-state silane. In addition, a steric hindrance of the silane is relatively low, facilitating generation of silicon oxide, thereby facilitating preparation of the protective layer 35, and helping to reduce a temperature or time required for preparing the protective layer 35, thereby helping to reduce a risk that excessive silane infiltrates into the electrode plate.

In some embodiments, an inlet flow rate Q1 of the gas-state silane, an inlet flow rate Q2 of the water vapor, and an inlet flow rate Q3 of the pH regulator satisfy: Q2 ≥ Q1 > Q3. In this way, it is beneficial to the reaction between the water molecules and the silane, and is also beneficial to reducing an amount of the silane.

In an example, inlet flow rates of the gas-state silane and the water vapor are the same.

In another example, the inlet flow rate of the water vapor is greater than the inflow rate of the silane.

The inlet flow rate Q3 of the pH regulator may refer to a rate at which the pH regulator is fed into the container.

For a case in which the carrier gas and the water vapor are simultaneously fed into the container, the inlet flow rate Q2 of the water vapor is a rate at which the mixed gas of the water vapor and the carrier gas is fed into the container. For a case in which only the water vapor is fed into the container, the inlet flow rate Q2 of the water vapor is a rate at which the water vapor is fed into the container.

For a case in which the carrier gas and the gas-state silane are simultaneously fed into the container, the inlet flow rate Q1 of the gas-state silane is a rate at which the mixed gas of the gas-state silane and the carrier gas is fed into the container. For a case in which only the gas-state silane is fed into the container, the inlet flow rate Q3 of the gas-state silane is a rate at which the water vapor is fed into the container.

In some embodiments, the inlet flow rate Q1 of the gas-state silane satisfies: 0.5 L/min ≤ Q1 ≤ 1.5 L/min; and/or the inlet flow rate Q2 of the water vapor satisfies the following: 1 L/min ≤ Q2 ≤ 2 L/min; and/or the inlet flow rate Q3 of the pH regulator satisfies: 0.1 L/min ≤ Q3 ≤ 1 L/min.

Q1 may be 0.5 L/min, 1 L/min, 1.5 L/min, or any value in the foregoing range; Q2 may be 1 L/min, 1.5 L/min, 2 L/min, or any value in the foregoing range; and Q3 may be 0.1 L/min, 0.5 L/min, 1 L/min, or any value in the foregoing range.

By setting inlet flow rates of the gas-state silane, the water vapor, and the pH regulator, the gas-state silane, the water vapor, and the pH regulator enter the container at suitable rates, so that the gas-state silane and the water vapor react on the metal surface, facilitating generation of the protective layer. In addition, this also helps to reduce a risk that the silane infiltrates into a position of bare metal of the electrode assembly.

In some embodiments, a reaction time t1 of the gas-state silane and the water vapor satisfies: 2 h ≤ t1 ≤ 8 h.

t1 may be 2 h, 4 h, 6 h, 8 h, or any value within the foregoing range.

The reaction time t1 may refer to a duration of feeding the gas-state silane and the water vapor into the container.

By setting t1 in the foregoing range, a protective layer 35 having a particular thickness can be generated in a relatively short time, and a risk of excessive deposition of the silane at a position of unexposed metal of the electrode assembly (for example, a position at which the active material layer is disposed) caused by the reaction time being excessively long can also be reduced.

In some embodiments, 4 h ≤ t1 ≤ 6 h. In this way, the protective layer 35 having the suitable thickness can be obtained in a relatively short time.

Conditions for preparing the protective layer 35 are related to the thickness and a shear strength of the protective layer 35. For example, a time for preparing the protective layer 35 is relatively short and a temperature for preparing the protective layer 35 is relatively low, and the protective layer 35 having a relatively suitable thickness and shear strength can be prepared at the position of the bare metal on the electrode plate in a relatively short time and a relatively low temperature. In addition, in the relatively short time and at the relatively low temperature, there is a relatively low risk that the silane infiltrates into the position of the unexposed metal of the electrode plate, and there is a relatively low probability that the protective layer 35 is generated at the position of the unexposed metal. Therefore, the electrical performance (for example, the cycling performance and the power) of the battery cell is less affected. By properly setting the reaction time t1 and the temperature T, it is beneficial to preparing the protective layer 35 having a relatively suitable thickness and shear strength, and the battery still has relatively good electrical performance.

In some embodiments, a pressure P in the container satisfies: 0.09 MPa ≤ P ≤ 0.11 MPa. In this way, the protective layer 35 can be generated under a normal pressure, to reduce preparing complexity. In addition, in comparison with a case in which the container is under a vacuum condition, a risk that the silane and the like infiltrate into positions such as the active material layer of the electrode assembly 33 can also be reduced.

In some embodiments, the container is in communication with an external environment. In other words, in the process of the reaction between the silane and the water molecules, the container is in communication with the external environment. In this way, a relatively stable pressure is maintained in the container.

In some embodiments, the preparation method further includes: feeding a carrier gas into a storage tank storing water, to obtain the water vapor. In this way, the water vapor can be obtained by using the carrier gas, to facilitate feeding the water vapor into the container.

In an example, the temperature of the silane is increased, so that the silane changes into the gas-state silane, and the gas-state silane is fed into the container; the carrier gas is fed into a storage tank storing the water, to change the water into the water vapor, and further, the water vapor is fed into the container; and the pH regulator gas is fed into the container.

In a possible implementation, an inlet flow rate Q4 of the carrier gas satisfies: 0.9 L/min ≤ Q4 ≤ 2.2 L/min. In this way, it is convenient to obtain the water vapor.

The inlet flow rate Q4 of the carrier gas and the inlet flow rate Q2 of the water vapor may satisfy 0.9Q2 ≤ Q4 ≤ 1.1Q2. In this way, it is beneficial to feeding a suitable amount of water vapor into the container, and it is further beneficial to maintaining pressure balance in the container.

In an example, Q4 is equal to Q2.

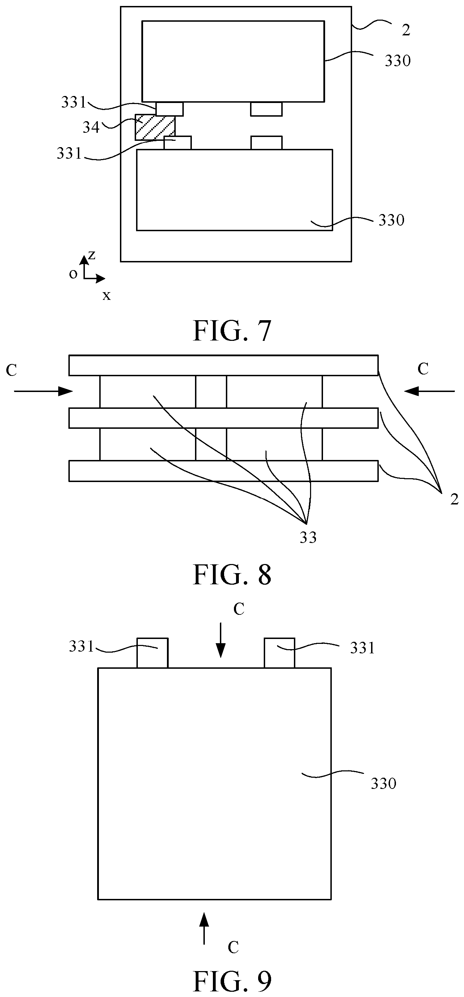

FIG. 7 is a schematic diagram of an electrode assembly connected to an end cover assembly according to an embodiment of the present application, and FIG. 8 is a schematic diagram of a bracket on which an electrode assembly is disposed. In FIG. 7, the end cover assembly 32 is located below the electrode assembly 33 (not shown in FIG. 7), and the tab 331 of the electrode assembly 33 is connected to the end cover assembly 32 through the current collecting member 34.

In some embodiments, for example, as shown in FIG. 7 and FIG. 8, step 210 includes: placing a plurality of electrode assemblies 33 connected to the end cover assembly 32 in a bracket 2, where the bracket 2 covers a surface of the electrode assemblies 33 having the largest area; and placing the bracket 2 loaded with the plurality of electrode assemblies 33 in the container. In this way, a component formed by connecting the plurality of electrode assemblies 33 and the end cover assembly 32 can be processed in the container, which is beneficial to improving production efficiency. In addition, the bracket 2 covers the surface having the largest area on the electrode assembly 33, which is further beneficial to reducing a risk that the silane and the like enter the interior of the electrode assembly 33.

FIG. 9 is a schematic diagram of deposition of silane and water vapor according to an embodiment of the present application. With reference to FIG. 8 and FIG. 9, after the gas-state silane and the water vapor enter the container, the silane and the water vapor can deposit on the surfaces of the electrode assembly 33 and the end cover assembly 32 along the first direction (a direction in which the tab 331 projects out of the main body portion 330), for example, a direction of an arrow C-C in FIG. 8 and FIG. 9. By controlling conditions of the preparation method for a battery cell, a risk at which the silane deposits at the position of unexposed metal on the electrode assembly 33 (for example, a position at which the active material is disposed) can be reduced, thereby reducing adverse effects on the cycling performance of the battery cell.

In the battery cell prepared according to the preparation method 200, along the C-C direction, content of the element Si measured at a position 5 mm away from an end surface 3301 (for example, a first end surface 3301a and a second end surface 3301b) of the electrode assembly 33 is less than 0.01 wt%, and the value is basically close to 0.

In some embodiments, the preparation method 200 further includes: before the feeding a gas-state silane and water vapor into the container, feeding an inert gas into the container, to evacuate air in the container. In this way, adverse effects of the air on the reaction between the silane and the water vapor can be reduced.

In an example, the inert gas fed into the container has a relatively high temperature. In this way, the container and the electrode assembly can be rapidly heated by using the inert gas having the relatively high temperature.

In some embodiments, a time t3 for which the inert gas is fed satisfies: 5 min ≤ t3 ≤ 30 min; and/or, an inlet flow rate V2 of the inert gas satisfies: 0.1 L/min ≤ V2 ≤ 2 L/min. In this way, the air in the container can be evacuated relatively quickly and efficiently.

The fed gas may be a gas such as nitrogen, helium, or argon.

The time t3 may be 5 min, 10 min, 30 min, or any value within the foregoing range, and the flow rate V2 may be 0.1 L/min, 1 L/min, 2 L/min, or any value within the foregoing range.

The time for which and the flow rate at which the inert gas is fed may be set according to an actual requirement, provided that the air inside the container can be evacuated.

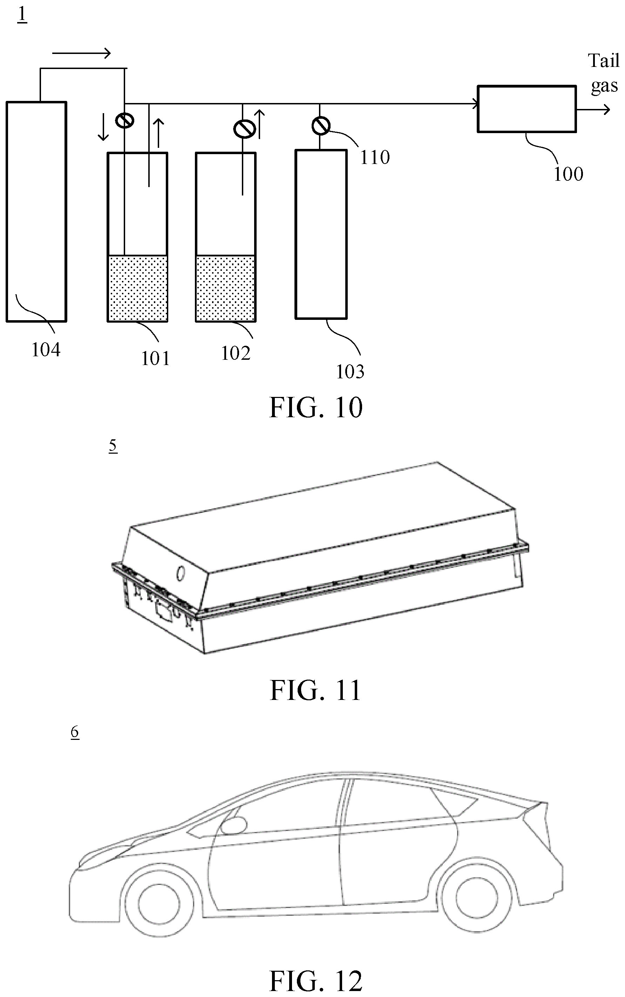

FIG. 10 is a schematic diagram of a device for preparing a protective layer according to an embodiment of the present application. For example, as shown in FIG. 10, a device 1 may include a container 100, a first storage tank 101, a second storage tank 102, a third storage tank 103, and a fourth storage tank 104. Each of the first storage tank 101, the second storage tank 102, the third storage tank 103, and the fourth storage tank 104 is provided with a flow regulating valve 110 and is in communication with the container 100. The container 100 is configured to accommodate an electrode assembly 33 connected to an end cover assembly 32, the first storage tank 101 is configured to store water, the second storage tank 102 is configured to store silane, the third storage tank 103 is configured to store a pH regulator, and the fourth storage tank 104 is configured to store nitrogen.

In a process of preparing a protective layer, first, an inert gas nitrogen in the fourth storage tank 104 may be fed into the container 100, to evacuate air from the container 100; a carrier gas nitrogen in the fourth storage tank 104 is fed into the first storage tank 101 to obtain water vapor, and further a mixed gas of the water vapor and the nitrogen to the container 100; the second storage tank 102, to obtain gas-state silane, and the gas-state silane is fed into the container 100; the pH regulator in the third storage tank 103 is fed into the container 100.

In the preparation method in the embodiments of the present application, the reaction time t1 and the temperature T are properly set, thereby helping to prepare a protective layer 35 having a relatively suitable thickness and shear strength while the battery still has relatively good electrical performance. The reaction between the silane and the water molecules on the metal surface is performed under a normal pressure, thereby helping reduce a risk that the silane infiltrates into the unexposed metal of the electrode assembly 33, and further reducing adverse effects on the electrical performance of the battery. By properly setting the flow rates of the gas-state silane, the water vapor, and the pH regulator, the reaction between the silane and the water module is facilitated, a risk that the silane infiltrates into the position of unexposed metal of the electrode assembly is reduced, and it is also beneficial to reducing a waste of the silane. By feeding the pH regulator into the container, it is beneficial to promoting the reaction between the silane and the water, it is also beneficial to preparing a protective layer 35 having a corresponding thickness at a relatively low temperature and in a relatively short time, and the battery has relatively good electrical performance.

### [Battery]

An embodiment of the present application provides a battery, including the battery cell 3 in the foregoing embodiments. FIG. 11 is a schematic diagram of a battery according to an embodiment of the present application. As shown in FIG. 11, a battery 5 may include a plurality of battery cells (which are not shown in the figure).

The battery cells 3 may directly form the battery 5, or may first form a battery module, and then a plurality of battery modules form the battery 5.

### [Power consuming apparatus]

An embodiment of the present application provides a power consuming apparatus, including the battery in the foregoing embodiment.

FIG. 12 is a schematic diagram of a power consuming apparatus according to an embodiment of the present application. As shown in FIG. 12, this embodiment of the present application provides a power consuming apparatus 6, including the battery in the foregoing embodiment.

Optionally, the power consuming apparatus may alternatively be an energy storage apparatus, a lighting apparatus, a spacecraft, or the like. This embodiment of the present application includes, but is not limited thereto.

Examples of the present application are described below. The examples described below are exemplary and only used to explain the present application, and should not be construed as a limitation on the present application. If the specific technology or conditions are not specified in the examples, the technology or conditions described in the literature in this field or the product manual shall be followed. All of the used agents or instruments which are not specified with manufacturers are conventional commercially-available products.

### [Examples of the preparation method for a battery cell]

### Example 1

(1) A positive electrode active material LiNi_{0.8}Co_{0.1}Mn_{0.1}O₂ (NCM811), conductive carbon black, and a binder polyvinylidene fluoride (PVDF) were fully stirred and mixed in a weight ratio of 93: 2: 5 in a proper amount of N-methylpyrrolidone (NMP) solvent, to form a uniform positive electrode slurry; and the positive electrode slurry was coated on copper foil with a thickness of 12 µm, followed by processes such as drying, rolling, splitting, and cutting to obtain the positive electrode plate.
(2) A negative electrode active material: graphite, conductive carbon black, a sodium carboxymethyl cellulose (CMC) thickener, and a styrene-butadiene rubber emulsion (SBR) binder were fully stirred and mixed in an appropriate amount of deionised water at a mass ratio of 96.5:1.0:1.0:1.5, to form a homogeneous negative electrode slurry. The negative electrode slurry was coated on copper foil with a thickness of 8 µm, followed by processes such as drying, to obtain the negative electrode plate.
(3) The positive electrode plate, a separator (a PE film having a thickness of 9 µm), and the negative electrode plate were sequentially stacked and then wound to obtain an electrode assembly, where the electrode assembly carried an aluminum positive electrode tab and a copper negative electrode tab; the positive and negative electrode tabs were respectively soldered to an aluminum positive electrode adapter plate and a copper negative electrode adapter plate, and then the positive and negative electrode adapter plates were respectively soldered to positive and negative electrode terminals of the end cover assembly, to obtain a battery member including the electrode assembly and the end cover assembly.
(4) The battery member was placed in a container, the container was heated to a temperature T, where the temperature T was 82°C, and meanwhile, nitrogen was fed into the container as a protective gas, where an inlet flow rate was 0.01 L/min and a feeding time was 30 min, to evacuate air in the container.
(5) Silane (CH₃)₂-Si(OCH₃)₂ was heated to 82°C (where the temperature was close to a boiling point of the silane), to obtain a gas-state silane; and the silane in the gas state was fed into the container, where an inlet flow rate was Q1.
(6) The nitrogen gas was fed into a storage tank storing water, to obtain water vapor; a mixed gas of the water vapor and the nitrogen gas was fed into the container, where the inlet flow rate was Q2, and a flow rate Q4 of the nitrogen gas into the storage tank storing water was approximately 0.9*Q2 to 1.1*Q2.
(7) A pH regulator was fed into the container, where the pH regulator was methylamine gas, and an inlet flow rate was Q3; and a total reaction duration t1 was controlled to 6 h.
(8) After the reaction time length was reached, feeding of the gas-state silane and the water vapor was stopped, and the container was cooled; then, the member including the electrode assembly and the end cover assembly were extracted from the container and were soldered to a housing, to assemble a battery cell.

### Examples 2 to 4

A difference between Examples 2 to 4 and Example 1 lies in that types of the pH regulator are different.

### Examples 5 to 8

A difference between Examples 5 to 8 and Example 1 lies in that temperatures T of the container are different.

### Examples 9 to 11

A difference between Examples 9 to 11 and Example 1 lies in that flow rates Q at which the gas-state silane, the water vapor, and the pH regulator are fed into the container are different.

### Examples 12 and 13

A difference between Examples 12 and 13 and Example 1 lies in that flow rates at which the pH regulators are fed into the container are different.

### Examples 14 to 16

A difference between Examples 14 to 16 and Example 1 lies in that reaction times are different.

### Examples 17 and 18

A difference between Examples 17 and 18 and Example 1 lies in that types of the silane are different.

### Comparative Example 1

A difference between Comparative Example 1 and Example 1 lies in that the pH regulator is not fed into the container.

### [Examples of the battery cell]

Examples 1 to 18 of the battery cell may be respectively prepared by using Examples 1 to 18 of the preparation method for a battery cell, and Comparative Example 1 of the battery cell may be obtained by using Comparative Example 1 of the preparation method for a battery cell.

**Table 1 Parameters in Examples and Comparative Examples of the preparation method for a battery cell**

| | Silane | pH regulator | Flow rate Q 1 /L/min | Flow rate Q2/L/min | Flow rate Q3/L/min | Reaction time t1/h | Container temperature T/°C |
|---|---|---|---|---|---|---|---|
| Example 1 | (CH₃)₂-Si(OCH₃)₂ | Methylamine | 1 | 1.5 | 0.5 | 6 | 82 |
| Example 2 | (CH₃)₂-Si(OCH₃)₂ | Ethylamine | 1 | 1.5 | 0.5 | 6 | 82 |
| Example 3 | (CH₃)₂-Si(OCH₃)₂ | Ammonia | 1 | 1.5 | 0.5 | 6 | 82 |
| Example 4 | (CH₃)₂-Si(OCH₃)₂ | Hydrogen fluoride | 1 | 1.5 | 0.5 | 6 | 82 |
| Example 5 | (CH₃)₂-Si(OCH₃)₂ | Methylamine | 1 | 1.5 | 0.5 | 6 | 45 |
| Example 6 | (CH₃)₂-Si(OCH₃)₂ | Methylamine | 1 | 1.5 | 0.5 | 6 | 60 |
| Example 7 | (CH₃)₂-Si(OCH₃)₂ | Methylamine | 1 | 1.5 | 0.5 | 6 | 100 |
| Example 8 | (CH₃)₂-Si(OCH₃)₂ | Methylamine | 1 | 1.5 | 0.5 | 6 | 120 |
| Example 9 | (CH₃)₂-Si(OCH₃)₂ | Methylamine | 0.5 | 1 | 0.1 | 6 | 82 |
| Example 10 | (CH₃)₂-Si(OCH₃)₂ | Methylamine | 1.5 | 2 | 1 | 6 | 82 |
| Example 11 | (CH₃)₂-Si(OCH₃)₂ | Methylamine | 2 | 1 | 1 | 6 | 82 |
| Example 12 | (CH₃)₂-Si(OCH₃)₂ | Methylamine | 1 | 1.5 | 0.1 | 6 | 82 |
| Example 13 | (CH₃)₂-Si(OCH₃)₂ | Methylamine | 1 | 1.5 | 1 | 6 | 82 |
| Example 14 | (CH₃)₂-Si(OCH₃)₂ | Methylamine | 1 | 1.5 | 0.5 | 2 | 82 |
| Example 15 | (CH₃)₂-Si(OCH₃)₂ | Methylamine | 1 | 1.5 | 0.5 | 4 | 82 |
| Example 16 | (CH₃)₂-Si(OCH₃)₂ | Methylamine | 1 | 1.5 | 0.5 | 8 | 82 |
| Example 17 | CH₂OCHCH₂-O-(CH₂)₃-Si(OCH₃)₃ | Methylamine | 1 | 1.5 | 0.5 | 6 | 82 |
| Example 18 | (H₅C₂O)₃Si-(CH₂)₃-NH-(CH₂)₃-Si(OC₂H₅)₃ | Methylamine | 1 | 1.5 | 0.5 | 6 | 82 |
| Comparative Example 1 | (CH₃)₂-Si(OCH₃)₂ | / | 0.05 | 0.1 | / | 12 | 82 |

**Table 2 Comparative Examples and Examples of the battery cell**

| | Thickness of the protective layer d1/nm | | | Shear strength G/MPa | Si content in different cases/% | | | | |
|---|---|---|---|---|---|---|---|---|---|
| | | | | | End surface after being immersed in an electrolyte | End surface before being immersed in an electrolyte | 0.5 mm away from the end surface | 3 mm away from the end surface | 5 mm away from the end surface |
| | Position of the tab | Position of the first end surface | Position of the second end surface | | | | | | |
| Example 1 | 110 | 108 | 108 | 100 | 24 | 24 | 0.5 | 0.02 | < 0.01 |
| Example 2 | 115 | 113 | 110 | 105 | 25 | 26 | 0.8 | 0.04 | < 0.01 |
| Example 3 | 108 | 106 | 106 | 98 | 22 | 23 | 0.5 | 0.02 | < 0.01 |
| Example 4 | 116 | 113 | 110 | 102 | 25 | 27 | 0.8 | 0.04 | < 0.01 |
| Example 5 | 35 | 33 | 30 | / | / | 10 | 0.2 | 0.02 | < 0.01 |
| Example 6 | 65 | 64 | 62 | / | / | 15 | 0.3 | 0.01 | < 0.01 |
| Example 7 | 154 | 153 | 150 | 143 | 27 | 29 | 1 | 0.05 | < 0.01 |
| Example 8 | 198 | 190 | 189 | 180 | 35 | 35 | 1.2 | 0.05 | < 0.01 |
| Example 9 | 85 | 85 | 80 | / | / | 18 | 0.3 | 0.01 | < 0.01 |
| Example 10 | 185 | 183 | 183 | 176 | 31 | 32 | 1.1 | 0.05 | < 0.01 |
| Example 11 | 170 | 168 | 165 | 156 | 30 | 31 | 1 | 0.05 | < 0.01 |
| Example 12 | 80 | 65 | 50 | / | / | 17 | 0.8 | 0.03 | < 0.01 |
| Example 13 | 150 | 150 | 149 | 132 | 28 | 28 | 1 | 0.05 | < 0.01 |
| Example 14 | 25 | 25 | 24 | / | / | 8 | 0.2 | 0.02 | < 0.01 |
| Example 15 | 60 | 58 | 56 | / | / | 13 | 0.3 | 0.02 | < 0.01 |
| Example 16 | 150 | 132 | 135 | 141 | 28 | 30 | 1.2 | 0.05 | < 0.01 |
| Example 17 | 90 | 89 | 87 | 80 | 17 | 18 | 0.3 | 0.01 | < 0.01 |
| Example 18 | 82 | 80 | 79 | 75 | 16 | 16 | 0.3 | 0.02 | < 0.01 |
| Comparative Example 1 | 110 | 108 | 108 | 98 | 14 | 14 | 14 | 13 | 10 |

**Table 3 Experimental results of Examples and Comparative Examples**

| | Short circuit status | Capacity retention rate/% |
|---|---|---|
| Example 1 | No | 90.1 |
| Example 2 | No | 89.8 |
| Example 3 | No | 90.2 |
| Example 4 | No | / |
| Example 5 | No | 90.5 |
| Example 6 | No | 91.1 |
| Example 7 | No | 88.5 |
| Example 8 | No | 88.2 |
| Example 9 | No | 91.0 |
| Example 10 | No | 89.5 |
| Example 11 | No | 89.0 |
| Example 12 | No | 90.5 |
| Example 13 | No | 90.2 |
| Example 14 | No | 89.5 |
| Example 15 | No | 88.9 |
| Example 16 | No | 88.5 |
| Example 17 | No | 90.2 |
| Example 18 | No | 90.3 |
| Comparative Example 1 | No | 78.5 |

It should be noted that, in Table 2, "/" indicates that no corresponding test has been performed. Specifically, tests for the shear strength and tests for content of the element Si on the end surface after immersion in the electrolyte are not performed in Examples 5, 6, 9, 12, 14, and 15.

### [Tests for the protective layer]

### (1) Test for a thickness of the protective layer

The electrode assembly is disassembled, and thicknesses of the protective layer at the first end surface 3301a, the second end surface 3301b, and the tab 331 of the positive electrode plate are respectively observed by using a scanning electron microscope (for example, ZEISSsigma300).

### (2) Test for the element Si in the protective layer at different positions of the electrode assembly

Element analysis is performed on a surface of a relevant region by using an energy-dispersive X-ray spectroscopy (EDS) matching the ZEISSsigma300, to detect the content of the element Si in the region. Distribution of elements may be obtained based on a data result of the instrument, so that a mass percentage of the element Si can be obtained.

In an environment of 60 °C, the electrode assembly is immersed in an electrolyte for 7 days, and the content of the element Si on the end surface is detected. A binding strength between the protective layer and a current collector of the electrode plate can be reflected according to a change of the content of the element Si on the end surface before and after immersion in the electrolyte.

In an example, the test for the Si content is performed by using the following method. Sampling is performed at the second end surface 3301b in a direction in which the active material layer is arranged (for example, with reference to FIG. 2, sampling is performed at the second end surface 3301b along the y direction), and a region with a size of 10 mm × 10 mm is cut to obtain a sample. The sample is placed in a test device to perform element tests, and quantitative analysis is performed with reference to a microbeam analysis-energy dispersive spectrometry in GB-T17359-2012, percentages of elements C, Ni, Co, Mn, O, and Si (when the active material in the electrode plate is a ternary material), or percentages of C, Fe, O, and Si (when the active material in the electrode plate is lithium iron phosphate) can be measured. If the Si content at a position 5 mm away from the second end surface 3301b is to be tested, the point 5 mm away from the second end surface 3301b may be positioned by using a scale in the device, and the Si content at the point is tested. Similarly, if Si contents at positions 3 mm and 0.5 mm away from the second end surface 3301b are to be tested, points 3 mm and 0.5 mm away from the second end surface 3301b may be positioned by using the scale in the device, and the Si contents at the points are tested.

It should be noted that when an insulation layer is disposed on the surface of the main body portion of the electrode plate, sampling needs to be performed avoiding a region of the insulation layer.

### (3) Short circuit test for a battery provided with the protective layer

Different positions of the electrode assembly provided with the protective layer respectively overlaps with an anode of a fully charged battery, and a short circuit (or fire) probability is recorded. Specifically, the electrode assembly provided with the protective layer is manufactured into a battery, and the battery is fully charged to 100% SOC. After the battery is disassembled after full charging, a position provided with the protective layer directly contacts with a negative electrode active material region, and a short circuit (or fire) condition is recorded. Being fully charged means that the battery is charged to 100% SOC under a specified current, for example, a lithium iron phosphate battery is charged to 3.65 V, and a ternary material battery is charged to 4.3 V.

### [Test for the shear strength]

A tab provided with the protective layer is used as a test sample, and the test sample is adhered to a stainless steel plate by using a double-sided tape. A length of the test sample exceeds a length of the stainless steel plate by a particular distance. A tensile testing machine clamps one end of the test sample that exceeds the stainless steel plate and pulls the test sample upward until the test sample is separated from the stainless steel plate. In an example, the test sample is adhered to the stainless steel plate by using a double-sided tape having a length of 15 mm. When the test stopped, a region on the test sample that has a size of 9 mm × 9 mm and that corresponds to the double-sided tape is separated from the stainless steel plate.

The shearing strength is calculated based on a measurement result of the tensile testing machine, where shearing strength = shearing force/adhesion area. In the foregoing example, the adhesion area is 9 mm × 9 mm.

It should be noted that, in the embodiments of the present application, a binding strength between the protective layer and the electrode assembly is relatively large. Therefore, a strength when a specified region of the to-be-tested sample is separated from the stainless steel plate (to be specific, the strength when the entire region of 9 mm × 9 mm is separated from the stainless steel plate) is tested rather than the strength when any region of the to-be-tested sample is separated from the stainless steel plate (to be specific, a strength when any position not in the length of 15 mm is separated from the stainless steel plate).

### [Performance test of the battery cell]

Charging and discharging tests are performed on the battery cell in an environment of 25°C. A charging and discharging cycle process is as follows: constant-current charging is performed to 4.25 V at a current of 1C; constant-voltage charging continues to be performed until a charging current is less than 0.05C; charging is paused for 30 min; constant-current discharging is performed to 2.5 V at a current of 1C; and discharging is paused for 30 min.

After a charging and discharging cycle, a discharge capacity of the battery cell is recorded as a first discharge capacity.

After 500 cycles of charging and discharging, a discharge capacity after 500 cycles is recorded, where capacity retention rate after 500 cycles = discharge capacity after 500 cycles/first discharge capacity.

In the embodiments of the preparation method for a battery cell, with reference to Examples 1 to 18, the preparation method for the electronic device in the embodiments of the present application is simpler and more convenient, and the electrode assembly provided with the protective layer can be obtained without performing vacuuming processing. In addition, in comparison with a method in which the vacuuming processing is performed in the process of preparing the protective layer, not performing the vacuuming processing helps to reduce a risk of excessive infiltration of the silane at a position of unexposed metal on the electrode assembly (a position of unexposed metal on the electrode plate). Because silicon oxide or the silicon element is not electrically conductive, the silane that deposits or the silicon oxide that is formed at the position of the unexposed metal affects electrical conductivity performance, and further affects electrical performance (for example, the capacity retention rate) of the battery cell. Therefore, the content of the element Si at a position that is 5 mm away from the end surface of the electrode plate and that is on the electrode plate prepared by using the method in the embodiments of the present application is very low, and the battery cell has a relatively high capacity retention rate.

With reference to Examples 1 to 18, as the distance from the end surface becomes smaller, the content of the element Si has a tendency of gradually increasing. This is related to a direction of feeding reactants into the container in the process of preparing the protective layer (refer to the schematic diagrams of FIG. 8 and FIG. 9 and the foregoing descriptions). In addition, after the electrode assembly is immersed for a specific time, the end surface of the electrode plate is tested again, and a particular amount of element Si still remains on the end surface. This may reflect that the protective layer does not easily fall off from the electrode plate.

In the embodiments of the present application, with reference to Examples 1 to 18 and Comparative Example 1, by adding the pH regulator, efficiency of the reaction between the silane and the water molecules is improved, the protective layer is generated in a shorter time, and a risk that the silicon oxide or the silicon element exists at the position of the unexposed metal of the electrode assembly is further reduced.

In Examples 1 to 18, a phenomenon of a short circuit or fire does not occur when the electrode plate provided with the protective layer overlaps an electrode of opposite polarity. Therefore, disposition of the protective layer can reduce a risk of the short circuit of the battery cell. In addition, the capacity retention rates of the battery cells in Examples 1 to 3 and Examples 5 to 18 after 500 cycles are approximately 90%. Therefore, the battery cell in the embodiments of the present application has relatively high reliability and high cycling performance.

With reference to Examples 1 to 4, an alkaline gas or an acid gas may be used as the pH regulator, to improve the reaction efficiency. With reference to Examples 1 to 3, in comparison with the pH regulator of the acid gas in Example 4, a battery cell prepared by using the alkaline gas as the pH has a higher capacity and a higher capacity retention rate. In Examples 1 to 3, the capacity retention rate is approximately 90%. In Example 4, the capacity retention rate is approximately 70.5%.

With reference to Examples 5 to 8, increasing of the temperature in the container helps to promote hydrolysis of the silane, thereby helping to generate a larger protective layer in a same time period. Further, when the temperature of the container is set in a range from 60 °C to 100 °C or from 80 °C to 100 °C, it is beneficial to obtaining a protective layer with a suitable thickness, and the temperature in the container is not excessively high.

With reference to Examples 9 to 11, when the flow rates of the gas-state silane, the water vapor, and the pH regulator that are fed into the container are increased, it is beneficial to obtaining a larger protective layer in a same time period. With reference to Examples 10 and 11, that the flow rate at which the water vapor is fed into the container is greater than the flow rate at which the gas-state silane is fed into the container helps execution of the reaction, and helps reduce the waste of the gas-state silane. With reference to Examples 12 and 13, by setting the flow rate at which the pH regulator is fed into the container in a range of 0.1 L/min to 1 L/min, the waste of the pH regulator can be reduced, and the reaction between the silane and the water molecules is facilitated.

With reference to Examples 14 to 16 and Example 1, a protective layer with a corresponding thickness can be generated within 2 h to 8 h, and the preparation method in the embodiments of the present application has relatively high efficiency. Further, with reference to Examples 1, 15, and 16, by setting the reaction time to 4 h to 6 h, a protective layer with an appropriate thickness can be prepared within a short time, and has high reaction efficiency.

With reference to Examples 17 and 18, the preparation method in the embodiments of the present application is applicable to a plurality of types of silane. Further, with reference to Example 1, a silane whose R group is a methyl group is selected, helping to obtain a relatively thick protective layer at a relatively low temperature.

It should be noted that the foregoing Examples and Comparative examples are described by using the positive electrode plate whose current collector is the aluminum foil. The embodiments of the present application are also applicable to a positive electrode plate and a negative electrode plate whose current collectors are another material.

It should be noted that the present application is not limited to the embodiments above. The foregoing embodiments are exemplary only, and any embodiment within the scope of the technical solution of the present application that has substantially the same composition and has the same effects as the technical idea is encompassed in the technical scope of the present application. In addition, other embodiments constructed by applying various modifications conceivable to those skilled in the art to the embodiments and combining some of the constituent elements of the embodiments without departing from the scope of the essence of the present application are also included in the scope of the present application.

## Claims

1. An electrode plate, wherein a protective layer is arranged at least on an end surface of the electrode plate, and the protective layer comprises silicon oxide;
based on a total mass of all elements at a first position of the electrode plate, a mass content A of element Si satisfies: A < 0.01 wt%, wherein the first position is a position 5 mm away from the end surface.

2. The electrode plate according to claim 1, wherein based on a total mass of all elements at a second position of the electrode plate, a mass content B of the element Si satisfies: B ≤ 0.05 wt%, wherein the second position is a position 3 mm away from the end surface.

3. The electrode plate according to claim 1 or 2, wherein based on a total mass of all elements at a third position of the electrode plate, a mass content C of the element Si satisfies: C ≤ 1.2 wt%, wherein the third position is a position 0.5 mm away from the end surface.

4. The electrode plate according to any one of claims 1 to 3, wherein based on a total mass of all elements on the end surface of the electrode plate, a mass content D of the element Si satisfies: 8 wt% ≤ D ≤ 35 wt%.

5. The electrode plate according to claim 4, wherein 15 wt% ≤ D ≤ 30 wt%.

6. The electrode plate according to any one of claims 1 to 5, wherein a thickness d1 of the protective layer satisfies: 20 nm ≤ d1 ≤ 200 nm.

7. The electrode plate according to claim 6, wherein 80 nm ≤ d1 ≤ 170 nm.

8. The electrode plate according to any one of claims 1 to 7, wherein a shear strength G of the protective layer satisfies: 70 MPa ≤ G ≤ 200 MPa.

9. The electrode plate according to claim 8, wherein 100 MPa ≤ G ≤ 150 MPa.

10. The electrode plate according to any one of claims 1 to 9, wherein the electrode plate comprises a main body portion and a tab, the tab projects out of the main body portion along a first direction, and the protective layer is arranged on at least some positions of an end surface of the main body portion along the first direction and the tab.

11. The electrode plate according to claim 10, wherein the protective layer is arranged on an end surface of the main body portion along a second direction, and the second direction is perpendicular to the first direction and parallel to a surface on which the electrode plate is located.

12. The electrode plate according to any one of claims 1 to 11, wherein the electrode plate is a positive electrode plate, the positive electrode plate comprises a positive electrode active material, and the positive electrode active material comprises layered transition metal oxide.

13. The electrode plate according to claim 12, wherein the layered transition metal oxide comprises at least one of LiNi_{0.8}Co_{0.1}Mn_{0.1}O₂ or LiNi_{0.6}Co_{0.2}Mn_{0.2}O₂.

14. An electrode assembly, comprising the electrode plate according to any one of claims 1 to 13.

15. A battery cell, comprising:
the electrode assembly according to claim 14; and
a housing, wherein the housing is configured to accommodate the electrode assembly.

16. A preparation method for a battery cell, comprising:
placing an electrode assembly in a container;
feeding a gas-state silane, water vapor, and a pH regulator into the container, to obtain an electrode assembly provided with a protective layer, wherein the protective layer comprises silicon oxide, and a general formula of the silane satisfies: R'-Si(OR)ₙ, wherein R' comprises an organic or inorganic functional group, R comprises an alkyl group, n is an integer, and 2 ≤ n ≤ 4; and
extracting the electrode assembly provided with the protective layer from the container and placing the electrode assembly in a housing, to obtain the battery cell.

17. The preparation method according to claim 16, wherein the pH regulator comprises an alkaline gas.

18. The preparation method according to claim 17, wherein the alkaline gas comprises at least one of ammonia, phosphine, methylamine, dimethylamine, trimethylamine, or ethylamine.

19. The preparation method according to claim 16, wherein the pH regulator comprises an acid gas.

20. The preparation method according to claim 19, wherein the acid gas comprises at least one of hydrogen fluoride, hydrogen sulfide, hydrogen chloride, or sulfur dioxide.

21. The preparation method according to any one of claims 16 to 20, wherein a temperature T of the container satisfies: 45 °C ≤ T ≤ 120 °C.

22. The preparation method according to claim 21, wherein the temperature T of the container 60 °C ≤ T ≤ 100 °C.

23. The preparation method according to any one of claims 16 to 22, wherein a boiling point of the silane is less than or equal to 200 °C.

24. The preparation method according to any one of claims 16 to 23, wherein the silane comprises at least one of (H₅C₂O)₃Si-CH₂CH₂-Si(OC₂H₅)₃, (H₅C₂O)₃Si-(CH₂)₃-NH-(CH₂)₃-Si(OC₂H₅)₃, (H₅C₂O)₃Si-(CH₂)₃-S₄-(CH₂)₃-Si(OC₂H₅)₃, (H₅C₂O)₃Si-(CH₂)₃-NH-CO-NH₂, CH₂OCHCH₂-O-(CH₂)₃-Si(OCH₃)₃, (CH₃)₂-Si(OCH₃)₂, or CH₃-Si(OCH₃)₃.

25. The preparation method according to claim 24, wherein the silane comprises (CH₃)₂-Si(OCH₃)₂.

26. The preparation method according to any one of claims 16 to 25, wherein an inlet flow rate Q1 of the gas-state silane, an inlet flow rate Q2 of the water vapor, and an inlet flow rate Q3 of the pH regulator satisfy: Q2 ≥ Q1 > Q3.

27. The preparation method according to any one of claims 16 to 26, wherein the inlet flow rate Q1 of the gas-state silane satisfies: 0.5 L/min ≤ Q1 ≤ 1.5 L/min; and/or the inlet flow rate Q2 of the water vapor satisfies the following: 1 L/min ≤ Q2 ≤ 2 L/min; and/or the inlet flow rate Q3 of the pH regulator satisfies: 0.1 L/min ≤ Q3 ≤ 1 L/min.

28. The preparation method according to any one of claims 16 to 27, wherein a reaction time t1 of the gas-state silane and the water vapor satisfies: 2 h ≤ t1 ≤ 8 h.

29. The preparation method according to claim 28, wherein 4 h ≤ t1 ≤ 6 h.

30. The preparation method according to any one of claims 16 to 29, wherein a pressure P in the container satisfies: 0.09 MPa ≤ P ≤ 0.11 MPa.

31. The preparation method according to any one of claims 16 to 30, wherein the container is in communication with an external environment.

32. The preparation method according to any one of claims 16 to 31, wherein the preparation method further comprises:
feeding a carrier gas into a storage tank storing water, to obtain the water vapor.

33. The preparation method according to claim 32, wherein an inlet flow rate Q4 of the carrier gas satisfies: 0.9 L/min ≤ Q4 ≤ 2.2 L/min.

34. The preparation method according to any one of claims 16 to 33, wherein the placing an electrode assembly in a container comprises:
placing a plurality of electrode assemblies in a bracket, wherein the bracket covers a surface having a largest area of the electrode assemblies; and
placing the bracket loaded with the plurality of electrode assemblies in the container.

35. The preparation method according to any one of claims 16 to 34, wherein the preparation method further comprises:
before the feeding a gas-state silane, water vapor, and a pH regulator into the container, feeding an inert gas into the container, to evacuate air in the container.

36. The preparation method according to any one of claims 16 to 35, wherein the placing an electrode assembly in a container comprises:
connecting the electrode assembly to an end cover assembly, and placing the electrode assembly connected to the end cover assembly in the container.

37. A battery, comprising the battery cell according to claim 15 and/or a battery cell obtained through the preparation method according to any one of claims 16 to 36.

38. A power consuming apparatus, comprising the battery according to claim 37.
